# EUROPÄISCHE PATENTSCHRIFT

(11) **EP 3 374 775 B1**
(45) Veröffentlichungstag und Bekanntmachung des Hinweises auf die Patenterteilung: **04.09.2019**
(21) Anmeldenummer: 16795004.7
(22) Anmeldetag: 09.11.2016
(51) Int. Cl.: G01R 1/067

(54) **KONTAKTSTIFT MIT LICHTQUELLE UND KONTAKTSTIFTANORDNUNG MIT LICHTQUELLE**
CONTACT PIN HAVING A LIGHT SOURCE AND CONTACT PIN ARRANGEMENT HAVING A LIGHT SOURCE
POINTE DE CONTACT DOTÉE D'UNE SOURCE DE LUMIÈRE ET AGENCEMENT DE POINTE DE CONTACT DOTÉ D'UNE SOURCE DE LUMIÈRE

(30) Priorität: 09.11.2015 DE 202015007901 U
(43) Veröffentlichungstag der Anmeldung: 19.09.2018
(73) Patentinhaber: Feinmetall GmbH, 71083 Herrenberg (DE)
(72) Erfinder: BÜSSE, Hans-Albert, 57627 Hachenburg (DE); DAHLHAUS, Kai, 72108 Rottenburg-Eckenweiler (DE); BURGOLD, Jörg, 71083 Herrenberg (DE)
(74) Vertreter: Clarenbach, Carl-Philipp
(86) Internationale Anmeldenummer: PCT/EP2016/077163
(87) Internationale Veröffentlichungsnummer: WO 2017/081096

(56) Entgegenhaltungen:
- US-A- 2 916 698
- US-A1- 2003 210 066
- US-A1- 2005 083 038
- US-A1- 2005 209 810
- US-A1- 2009 021 276
- US-A1- 2010 118 135
- US-A1- 2015 109 016

## Beschreibung

Die Erfindung betrifft einen Kontaktstift, insbesondere Federkontaktstift, mit einer Mantelhülse, in der ein Kontaktkolben längsverschieblich geführt ist. In der Ausbildung als Federkontaktstift ist in der Mantelhülse ein Federelement, insbesondere eine Schraubenfeder, angeordnet, die den Kontaktkolben mit seiner Kontaktspitze aus der Mantelhülse axial heraus drängt, sodass der Kontaktkolben entgegen der Kraft des Federelements in die Mantelhülse einfedern kann. Dabei wird insbesondere durch einen Formschluss, der insbesondere durch eine Verjüngung der Mantelhülse realisiert ist, verhindert, dass der Kontaktkolben durch das Federelement vollständig aus der Mantelhülse herausgedrängt werden kann.

Weiterhin betrifft die Erfindung eine Kontaktstiftanordnung mit einem Kontaktstift, insbesondere nach einem oder mehreren der vorhergehenden Ansprüche, und mit einer den Kontaktstift zumindest teilweise aufnehmenden Montagehülse, wobei der Kontaktstift einen verschieblich geführten Kontaktkolben aufweist.

Kontaktstifte und Kontaktstiftanordnungen der eingangs genannten Art sind aus dem Stand der Technik bereits bekannt.

In der Fertigungsindustrie, insbesondere der Automobilindustrie, hat die Qualitätskontrolle eine hohe Bedeutung. Beispielsweise werden in der Kabelbaumfertigung alle Steckverbinder eines Kabelbaums auf Prüftischen in sogenannte Prüfmodule eingesteckt, welche den passenden Gegenstecker simulieren. Die Prüfmodule bilden somit einen so genannten Prüfadapter in der Elektronikindustrie. Jeder Steckverbinder im Kabelbaum stellt ein Testobjekt (DUT = Device under test) dar. Die Prüfung der Steckverbinder umfasst dabei sowohl elektrische Tests als auch mechanische Tests. Dazu sind im Prüfmodul verschiedene Kontaktstifte (KS) eingebaut, welche auf den jeweiligen Test spezialisiert sind.

Diese Prüftechnik kann als Endtest nach der Herstellung eines vollständigen Kabelbaums angewandt werden oder auch bereits während der Montage zum Einsatz kommen. Einzelkabel mit vorkonfektionierten Kontaktelementen (Terminals) werden häufig über Rastverbindungen in ein Steckergehäuse montiert. Dies kann am Montageplatz oder am Prüfmodul durchgeführt werden. Ist das Deckelgehäuse bereits in dem Prüfmodul angeordnet, so können bestimmte Tests beim Bestücken ausgeführt werden. Vorteil ist, dass Bestückungsfehler sofort erkannt und korrigiert werden können.

Bei einem dieser Tests wird beispielsweise ein Kontaktstift mit hoher Federkraft gegen das zu prüfende Kontaktelement gedrückt und dadurch die Rastverbindung geprüft. Verrutscht das Kontaktelement, so wird ein (mechanischer) Fehler erkannt, beispielsweise mithilfe einer sogenannten Schalthülse. Unterstützt oder ersetzt wird die Prüfung der Verrastung neuerdings dadurch, dass am Kabel durch den Monteur oder Prüfer zusätzlich oder ausschließlich eine Zugkraft ausgeübt wird. Daher spricht man in diesem Fall auch von einem Zug-Test oder Pull-Test.

Wird beim Durchführen der Prüfung ein Fehler erkannt, wird die Fehlerstelle auf dem Prüftisch und innerhalb des Prüfmoduls üblicherweise über eine Test-Software lokalisiert und üblicherweise dem Prüfer beziehungsweise Operator auf einem Monitor oder Display angezeigt. Außerdem ist es bekannt, an jedem Prüfmodul eine Leuchtanzeige vorzusehen, die über den Zustand der einzelnen Kontaktelemente im Testobjekt Auskunft gibt. So zeigt beispielsweise eine aktivierte Leuchtanzeige an, dass das Testobjekt oder das prüfte Teil des Testobjekts in Ordnung ist, und eine deaktivierte Leuchtanzeige, dass ein Fehler vorliegt.

Die Fehleranzeigen können mehr oder weniger eindeutig erfasst und interpretiert werden. Deshalb gibt es Weiterentwicklungen, bei welchen das visuelle Signal durch die Leuchtanzeige in Form eines Leuchtpunkts nahe an der physischen Fehlerstelle am Testobjekt angezeigt wird. Dadurch erfolgt zusätzlich oder anstelle der optischen Darstellung mittels eines Displays oder Monitors eine Fehleranzeige direkt am Testobjekt beziehungsweise am Prüfmodul/-adapter.

Diese Technik erlaubt es außerdem auch, Fehler insbesondere bei einer Montage zu vermeiden. So werden die Leuchtpunkte beispielsweise dazu benutzt, den Monteur bei der Bestückung des Prüfmoduls oder Steckverbinders durch den Montageprozess zu führen. Schritt für Schritt werden die entsprechend zu bestückenden Kavitäten in den verschiedenen Steckern auf dem Prüftisch überleuchtet, sodass der Monteur beispielsweise nur den Leuchtpunkten, die beispielsweise farbig kodiert sind, folgen muss. Dieses Vorgehen kann auch als lichtgeführte Kontakteinsetzung (LGKE) bezeichnet werden.

Die Beleuchtung erfolgt dabei sinnvollerweise von unten, also vom Boden des Prüfmoduls her, durch das Testobjekt hindurch in Richtung des Operators beziehungsweise Prüfers. Die Erzeugung des jeweiligen Lichtpunkts kann mittels einer Leuchtdiode (LED) realisiert werden, die in unmittelbarer Nähe eines zu prüfenden beziehungsweise zu bestückenden Kontaktelements oder Kontaktstifts des Prüfmoduls beziehungsweise neben dem Kontaktstift in dem Prüfmodul eingebaut ist. In der Regel enthält der zu prüfende Steckverbinder eine Vielzahl von Kontaktelementen beziehungsweise Kabeln, die meist in einem engen Raster von wenigen Millimetern zueinander angeordnet sind. Im Bereich der Lichterzeugung beziehungsweise Einkopplung sind außerdem die eigentlichen Prüfmittel, die Kontaktstifte angeordnet. In dem engen Raster ist die exakte, eindeutig abgegrenzte Markierung der Fehlerstelle beziehungsweise der Montagestelle unmöglich. Zumal der Leuchtpunkt idealerweise auch noch im vollbestückten Zustand des Prüfadapters/Prüfmoduls sichtbar sein soll. Abhilfe wird bisher durch Lichtwellenleiter (LWL) geschaffen, die das Licht über außerhalb des Prüfmoduls sitzende (größere) Leuchtquellen punktuell an einem Bereich neben der Markierstelle leiten.

Mit kleiner werdendem Raster wird das Anwenden dieser Technik jedoch schwieriger bis ausgeschlossen, weil entweder nur eine vollständige lichtoptische Indikation am Bestückungsort jedes Kontaktelements realisierbar ist oder die zum vollständigen Test notwendige Kontaktstift-Kontaktierung jedes Kontaktelements. Dies bedingt dann eine Prozesstrennung, bei welcher beispielsweise zuerst die lichtgeführte Montage und anschließend die Prüfung ohne Beleuchtung oder Beleuchtungsmöglichkeit stattfindet. Die daraus resultierende Funktionseinschränkung für die Prüfung von Testobjekten mit kleinem Raster mindert damit den Vorteil der lichtgeführten Kontakteinsetzung. US 2,916,698 A zeigt eine Kontaktstiftanordnung.

Der Erfindung liegt daher die Aufgabe zugrunde, den oben genannten Nachteil zu beheben und sowohl eine Kontaktierung von Kontaktelementen als auch eine lichtgeführte Kontakteinsetzung bei engen Rastern ohne notwendige Prozesstrennung zu gewährleisten.

Die der Erfindung zugrundeliegende Aufgabe wird durch einen Kontaktstift mit den Merkmalen des Anspruchs 1 gelöst. Dieser hat den Vorteil, dass der zur Verfügung stehende Bauraum optimal ausgenutzt wird und der Konflikt zwischen Leuchtpunkt und Kontaktstiftraster gelöst wird. Dazu wird das Vorhandensein des Kontaktstifts dazu genutzt, gleichzeitig auch die Beleuchtungsfunktion zu realisieren. Erfindungsgemäß ist hierzu vorgesehen, dass mindestens eine Lichtquelle im Inneren des Kontaktstifts angeordnet ist, die ein elektrisch aktivierbares Leuchtmittel aufweist, wobei der Kontaktstift eine Lichtaustrittsöffnung für von der Lichtquelle ausgesandtes Licht besitzt. Damit ist die Lichtquelle direkt in den Kontaktstift integriert, und stellt somit keine Konkurrenz für den Kontaktstift in Bezug auf den vorhandenen Bauraum mehr dar. Dadurch, dass die Lichtquelle ein elektrisch aktivierbares Leuchtmittel aufweist, wird das Licht direkt im Kontaktstift erzeugt, es findet somit eine direkte Beleuchtung im beziehungsweise am Kontaktstift statt, sodass auf eine externe Lichtquelle und einen Lichtleiter verzichtet wird. Dabei kann die erfindungsgemäße Ausbildung des Kontaktstifts bei technisch unterschiedlichen Kontaktstiften realisiert werden. So ist der Kontaktstift gemäß einer ersten bevorzugten Ausführungsform selbst ohne elektrische Funktion, abgesehen von dem Leuchtmittel, als Leuchtkontaktstift ausgebildet, bei welchem der Kontaktkolben entgegen der Kraft eines Federelements. Gemäß einer zweiten Ausführungsform ist der Kontaktstift bevorzugt als elektrisch leitfähiger Prüf-Kontaktstift ausgebildet, der im engen Raster sowohl die lichtgeführte Kontakteinsetzung als auch die elektrische Prüfung des Testobjekts ermöglicht. Der Kontaktstift ist dabei bevorzugt als Federkontaktstift ausgebildet. Gemäß einer dritten Ausführungsform ist bevorzugt vorgesehen, dass der Kontaktstift als Schaltkontaktstift oder Schalthülse ausgebildet ist. In jedem der drei Fälle ist die erfindungsgemäße Ausbildung des Kontaktstifts realisierbar und führt zu den bereits genannten Vorteilen. Selbstverständlich ist es auch denkbar, den erfindungsgemäßen Kontaktstift in noch weiteren Kontaktstiftarten, die obenstehend nicht genannt wurden, zu realisieren beziehungsweise umzusetzen. Weiterhin ist bevorzugt vorgesehen, dass die Mantelhülse des Kontaktstifts einteilig ausgebildet ist. Alternativ ist bevorzugt vorgesehen, dass die Mantelhülse mehrteilig ausgebildet ist, mit einem ersten Teil, in welchem der Kontaktkolben längsverschieblich gelagert ist, und in welchem insbesondere auch das Federelement angeordnet ist, und mit einem zweiten Teil, der insbesondere zur Befestigung des Kontaktstifts in einem Prüfadapter und/oder einer Montagehülse ausgebildet ist. Die Lichtquelle ist dann bevorzugt in dem ersten oder in dem zweiten Teil angeordnet. Beispielsweise kann die Lichtquelle in beziehungsweise an einem Anschlussstück angeordnet sein, das auf die Mantelhülse auf- und/oder in die Mantelhülse einsteckbar ist. Auch kann der zweite Teil des Kontaktstifts beziehungsweise der Mantelhülse von der bereits genannten Montagehülse gebildet werden.

Gemäß einer bevorzugten Weiterbildung der Erfindung ist vorgesehen, dass die Lichtaustrittsöffnung an oder im Bereich einer Kontaktierungsfläche und/oder zur Kontaktierungsfläche benachbarter Fläche/Flächen des Kontaktkolbens und/oder an oder im Bereich eines dem Kontaktkolben benachbart liegenden Endes der Mantelhülse liegt. Die Lichtaustrittsöffnung ist insoweit derart ausgewählt, dass das von der Leuchtquelle erzeugte Licht zumindest im Wesentlichen axial oder zumindest im Wesentlichen radial aus dem Kontaktstift austritt. Dazu liegt die Austrittsöffnung entweder stirnseitig (axial) oder mantelwandseitig (lateral) in der Mantelhülse oder im Kontaktkolben ausgebildet. Insbesondere ist die wenigstens eine Lichtaustrittsöffnung derart an dem Kontaktkolben und/oder der Mantelhülse ausgebildet, dass sie in Abhängigkeit von der Schiebestellung des Kontaktkolbens freigegeben oder verschlossen ist. Damit wird der Strahlengang des Lichts durch die Bewegung des Kontaktkolbens beeinflusst und eine automatisierte Signalgebung beim Durchführen eines Prüfvorgangs auf einfache Art und Weise erreicht.

Gemäß einer bevorzugten Weiterbildung der Erfindung ist vorgesehen, dass die Lichtquelle dazu ausgebildet ist, Licht im für das menschliche Auge sichtbaren Spektrum, oder im nicht-sichtbaren Spektrum, insbesondere im IR-Spektrum und/oder im UV-Spektrum, aus zu senden. Insbesondere dann, wenn die Lichtquelle Licht im für das menschliche Auge sichtbaren Spektrum aussendet, ist eine einfache Integration und Benutzung des Kontaktstifts für den Fachmann, insbesondere für den Monteur/Prüfer möglich, welche die lichtgeführte Kontakteinsetzung vereinfacht. Um Licht im sichtbaren Spektrum zu erzeugen, ist die Lichtquelle insbesondere als Leuchtdiode (LED), vorzugsweise als SMD-Chip, vorzugsweise seitlich abstrahlend, axial abstrahlend, mit klassischer Rundform, als Nackt-Chip oder vergossen, einfarbig oder mehrfarbig und einfach oder mehrfach in dem Kontaktstift vorhanden. Auch ist es denkbar, als Lichtquelle eine Laser-Lichtquelle, insbesondere als SMD-Chip, in dem Kontaktstift anzuordnen. Durch das Aussenden von Licht im nicht sichtbaren Spektrum wird eine für den Prüfer selbst nicht ersichtliche Leucht- oder Farbmarkierung ermöglicht, die beispielsweise von einer Kameraeinrichtung zur automatischen Auswertung des Leuchtsignals nutzbar ist.

Weiterhin ist bevorzugt vorgesehen, dass die Lichtquelle dazu ausgebildet ist, betriebszustandsabhängig Licht in unterschiedlichen Farben aus zu senden. Hierdurch wird die zuvor beschriebene farbliche Codierung des Lichts ermöglicht, welche die lichtgeführte Kontakteinsetzung vereinfacht.

Weiterhin ist bevorzugt vorgesehen, dass die Lichtquelle mit einer Steuerung verbunden/verbindbar ist, die dazu ausgebildet ist, die Lichtquelle ein- und aus zu schalten, getaktet und/oder zur Abgabe von Licht mit unterschiedlichen Farben an zu steuern. Die Steuerung ist bevorzugt in dem Kontaktstift angeordnet, sodass der Kontaktstift zusammen mit der Lichtquelle und der Steuerung eine kompakte Einheit bildet, die eigenständig funktioniert. Alternativ ist die Steuerung extern angeordnet, sodass mehrere Kontaktstifte mit ein und derselben Steuerung verbunden sein können, welche dann optional die mehreren Kontaktstifte überwacht und in jedem Fall deren Lichtquellen ansteuert.

Weiterhin ist bevorzugt vorgesehen, dass die Lichtquelle in einem die Kontaktierungsfläche aufweisenden Endbereich des Kontaktkolbens, angrenzend an die Lichtaustrittsöffnung angeordnet ist, oder dass die Lichtquelle Licht in einen Lichtdurchgangskanal einstrahlt, der die Lichtaustrittsöffnung, und insbesondere mindestens eine Lichteintrittsöffnung, aufweist beziehungsweise in diese mündet. Damit ist die Lichtquelle entweder direkt der Lichtaustrittsöffnungen zugeordnet oder beabstandet zu dieser angeordnet, wobei dann das Licht durch den Lichtdurchgangskanal von der Lichtquelle bis zu der Lichtaustrittsöffnung geführt wird. Je nach Ausführungsform des Kontaktstifts, beispielsweise als Federkontaktstift oder Schaltkontaktstift, bietet sich die eine oder die andere Anordnung der Lichtquelle an.

Gemäß einer vorteilhaften Weiterbildung der Erfindung ist der Lichtquelle vorzugsweise ein Kollimator beziehungsweise eine Kollimator-Linse zugeordnet. Durch den Kollimator wird aus dem von der Lichtquelle kugelförmig austretenden Licht ein Bündel von parallelen Lichtstrahlen erzeugt, wobei dieses Strahlenbündel in eine gewünschte Richtung ausrichtbar oder ausgerichtet ist. Der Kollimator beziehungsweise die Sammellinse ist dazu vorzugsweise in einem kurzen Abstand zu dem oder den Leuchtmitteln der Lichtquelle angeordnet, insbesondere in der Kollimatorbrennweite. Durch das Bündeln des Lichts zu parallelen Lichtstrahlen kann dieses gezielt in den Lichtdurchgangskanal beziehungsweise die Lichteintrittsöffnung des Lichtdurchgangskanals gerichtet werden. Durch die Bündelung des Lichts mittels des Kollimators wird erreicht, dass insbesondere bei einem längeren/langen Lichtdurchgangskanal eine ausreichend sichtbare Lichtintensität an der Lichtaustrittsöffnung erhalten bleibt, weil das Licht durch die Bündelung weniger an Hindernissen im Lichtdurchgangskanal reflektiert und/oder absorbiert wird, also weniger abgeschwächt wird. Vorzugsweise weist die Lichtquelle die Sammellinse beziehungsweise den Kollimator auf. Dazu ist beispielsweise der Kollimator an einem Träger, insbesondere Leiterplatte, für das oder die Leuchtmittel angeordnet.

Gemäß einer bevorzugten Weiterbildung der Erfindung ist vorgesehen, dass der Lichtdurchgangskanal den Kontaktkolben, eine dem Kontaktkolben zugeordnete Feder, die Mantelhülse, einen in der Mantelhülse liegenden Innenaufbau des Kontaktstifts und/oder den gesamten Kontaktstift zumindest bereichsweise durchsetzt. Dadurch wird gewährleistet, dass das Licht von der Lichtquelle bis zu der Lichtaustrittsöffnung zumindest im Wesentlichen störungsfrei gelangt, um an der Lichtaustrittsöffnung die maximal mögliche Lichtstärke zu gewährleisten, die ein sicheres Auslesen der durch die Lichtquelle gegebenen Leucht-Kodierung ermöglicht.

Weiterhin ist bevorzugt vorgesehen, dass die Lichtquelle an einen elektrischen Strompfad angeschlossen ist, der zu einer von außen zugänglichen elektrischen Schnittstelle des Kontaktstifts oder der bereits genannten Montagehülse für den Kontaktstift führt. Dadurch ist die Lichtquelle einfach mit elektrischer Energie versorgbar und durch die Steuerung betreibbar. Die elektrische Verbindung erfolgt dabei beispielsweise entweder direkt durch den Kontaktstift selbst oder indirekt unter Zwischenschaltung der den Kontaktstift aufnehmenden Montagehülse, wie mit Bezug auf die erfindungsgemäße Kontaktstiftanordnung unten näher beschrieben ist. Bei dem Strompfad handelt es sich in einer ersten Ausführungsform um den Test-Strompfad, welcher von dem Kontaktstift zur elektrischen Kontaktierung des Testobjekts beziehungsweise des Prüflings genutzt wird. Damit liegt die Lichtquelle elektrisch in dem gleichen Strompfad, der auch für einen elektrischen Test des Testobjekts genutzt wird. Gemäß einer zweiten Ausführungsform ist die Lichtquelle an einen eigenen Licht-Strompfad angeschlossen, der unabhängig von einem gegebenenfalls vorhandenen Test-Strompfad ausgebildet ist.

Gemäß einer bevorzugten Weiterbildung der Erfindung ist vorgesehen, dass der Strompfad, insbesondere der Licht-Strompfad oder der Test-Strompfad, zumindest abschnittsweise von einem den Kontaktkolben mit einer Federkraft beaufschlagenden Federelement gebildet wird, das elektrisch leitfähig ausgebildet ist. Damit wird das in einem herkömmlichen Federkontaktstift ohnehin vorhandene Federelement dazu genutzt, den Strompfad, insbesondere den Licht-Strompfad, mit zu bilden. Hierdurch ist eine einfache elektrische Anbindung der Lichtquelle an die elektrische Schnittstelle, insbesondere an die Montagehülse gewährleistet. Für die elektrisch leitfähige Ausbildung des Federelements, das vorzugsweise als Schraubenfeder ausgebildet ist, ist vorgesehen, das das Federelement aus einem elektrisch leitfähigen Material gefertigt ist oder mit zumindest einem elektrisch leitfähigen Leiter versehen ist. Bevorzugt weist das Federelement eine elektrisch isolierende Beschichtung auf, sodass das Federelement elektrisch isoliert zu benachbarten Bauteilen des Kontaktstifts, insbesondere der Mantelhülse oder einem weiteren Federelement ist. In diesem Fall ist dann die elektrische Isolation lediglich an den Kontaktstellen zu der Lichtquelle oder einer die Lichtquelle tragenden Leiterplatte oder Schaltung sowie zu der elektrischen Schnittstelle durchbrochen. Insbesondere sind dazu die Enden der Schraubenfeder beschichtungsfrei zur elektrischen Kontaktierung ausgebildet. Gemäß einer vorteilhaften Weiterbildung ist außerdem vorgesehen, dass zwei Federelemente vorhanden sind, die parallel zueinander wirken und als Schraubenfedern insbesondere koaxial zueinander in dem Kontaktstift angeordnet sind und jeweils einen Strompfad mitbilden, wobei die beiden Strompfade elektrisch voneinander getrennt sind. Dazu sind die beiden Federelemente beziehungsweise Schraubenfedern ebenfalls mit einer elektrisch isolierenden Schicht versehen. Der Kontaktkolben wird dann entgegen der Kraft der beiden Federelemente in die Mantelhülse bei Kraftbeaufschlagung eingefedert. Durch das Integrieren beziehungsweise Ausbilden eines Strompfads in das jeweilige Federelement wird eine bauraumsparende Stromführung in dem Kontaktstift erreicht. Gemäß einer weiteren Ausführungsform ist bevorzugt vorgesehen, dass das abschnittsweise Mitbilden eines Strompfads durch zumindest ein Federelement, wie es obenstehend beschrieben wurde, bei einem Kontaktstift ohne Lichtquelle eingesetzt wird, der beispielsweise als einfacher Federkontaktstift oder Schaltkontaktstift oder dergleichen ausgebildet ist. Auch hier bietet die Integration des Strompfads in das Federelement Vorteile in Bezug auf den vorhandenen Bauraum. Insbesondere kann dadurch der Federkontaktstift/Kontaktstift auch kleiner dimensioniert werden als bisher. Auch hierbei sind bevorzugt wenigstens zwei koaxial zueinander angeordnete und elektrisch leitfähige Schraubenfedern vorgesehen, die elektrisch voneinander getrennt sind, um zwei unterschiedliche Strompfade herzustellen, wie zuvor bereits beschrieben. Vorzugsweise ist die Lichtquelle an eine sich im Kontaktstift oder in der genannten Montagehülse befindlichen elektrische/elektronische Schaltung angeschlossen.

Gemäß einer bevorzugten Weiterbildung ist vorgesehen, dass der Lichtdurchgangskanal mindestens ein Lichtbeeinflussungsmittel aufweist, das insbesondere als ein Lichtreflektionsmittel, ein Lichtstreumittel, ein Lichteinfärbungsmittel ausgebildet und/oder mindestens eine optische Linse, insbesondere Kollimator, mindestens ein Lichtfilter und/oder mindestens eine Lichtblende ist. Das Lichtbeeinflussungsmittel ist direkt im Lichtdurchgangskanal angeordnet, wodurch der Lichtdurchgangskanal vorteilhaft zur Beeinflussung des von der Lichtquelle erzeugten Lichts genutzt wird. Da der Lichtdurchgangskanal je nach Ausführungsform des Kontaktstifts ohnehin vorhanden ist, wird dadurch der vorhandene Bauraum im Kontaktstift optimal ausgenutzt. Optional weist der Lichtdurchgangskanal über seine Länge mindestens eine Durchmesseränderung auf. Durch die Durchmesseränderung wird beispielsweise der Vorteil erreicht, dass eine axiale Anlagefläche beziehungsweise eine Stufe erzeugt wird, an welcher insbesondere das genannte Lichtbeeinflussungsmittel anordenbar und befestigbar ist. Insbesondere ist vorgesehen, dass an der Mantelhülse des Kontaktstifts oder an dem Kontaktkolben, insbesondere der Kontaktspitze, wenigstens eine der Lichtaustrittsöffnung zugeordnete Reflektionsfläche angeordnet ist, an welcher das die Lichtaustrittsöffnung verlassene Licht in die Umgebung vorteilhaft reflektiert wird. So ist die Reflektionsfläche bevorzugt als Reflektionsring ausgebildet, der sich über den gesamten Umfang des Kontaktstifts erstreckt, sodass der Operator ein ringförmiges Lichtsignal erkennen kann. Die Reflektionsfläche ist beispielsweise in den Kontaktkolben, die Kontaktspitze oder die Mantelhülse integriert ausgebildet, oder durch einen separaten Reflektionsring, der auf den Kontaktkolben, die Kontaktspitze oder die Mantelhülse aufgeschoben ist, gebildet. Weiterhin ist bevorzugt vorgesehen, dass in dem Kontaktkolben und/oder der Mantelhülse mehrere Lichtaustrittsöffnungen axial hintereinanderliegend angeordnet sind, die in Abhängigkeit der Schiebestellung des Kontaktkolbens von der Mantelhülse oder dem Kontaktkolben freigegeben oder verschlossen/verdeckt werden, sodass in Abhängigkeit der Kolbenstellung unterschiedliche Lichtsignale von dem Kontaktstift ausgesendet werden. Auch ist es denkbar, eine Lichteintrittsöffnung des Lichtdurchgangkanals in Abhängigkeit der Schiebestellung des Kontaktkolbens freizugeben und zu verschließen. Insbesondere dann, wenn das Leuchtmittel beziehungsweise die Lichtquelle an/in der Montagehülse oder in/an einem Anschlussstück der Montagehülse oder des Kontaktstifts angeordnet ist, ist eine Beeinflussung der Lichteintrittsöffnung in Abhängigkeit der Schiebestellung des Kontaktkolbens bauraumsparend realisierbar. Insbesondere ist vorgesehen, dass in der nicht eingefederten Stellung des Kontaktkolbens die an dem Kontaktkolben ausgebildete Lichteintrittsöffnung des Lichtdurchgangskanals beabstandet zu einem Schließelement der Montagehülse und/oder des Anschlussstücks angeordnet ist. Federt der Kontaktkolben aufgrund eines Testvorgangs ein, so nähert er sich mit der Lichteintrittsöffnung dem Schließelement, bis dieses die Lichteintrittsöffnung vollständig verschließt, sodass ein weiterer Lichtdurchgang verhindert ist.

Weiterhin ist bevorzugt vorgesehen, dass die Lichtquelle, insbesondere der Licht-Strompfad, elektrisch galvanisch getrennt ist von mindestens einem elektrischen Test-Strompfad des Kontaktstifts und/oder der genannten Montagehülse. Dadurch wird erreicht, dass der Betrieb der Lichtquelle unabhängig von dem Testbetrieb des Kontaktstifts erfolgt. Insbesondere ein Kurzschluss zwischen den beiden elektrischen Strompfaden, also dem der Lichtquelle zugeordneten Licht-Strompfad und einem elektrischen Test-Strompfad des Kontaktstifts, wird dadurch sicher verhindert. Die elektrische/galvanische Trennung wird beispielsweise durch eine auf den jeweiligen Strompfad aufgebrachte elektrisch isolierende Beschichtung gewährleistet, wie beispielsweise in Bezug auf das elektrisch leitfähige Federelement oder die elektrisch leitfähigen Federelemente bereits beschrieben.

Ferner verläuft der Lichtdurchgangskanal bevorzugt zumindest abschnittsweise entlang, parallel und/oder schrägwinklig zu einer Mittellängsachse des Kontaktstifts oder der genannten Montagehülse. Durch den parallelen Verlauf ist das Licht insbesondere beispielsweise von einem Ende des Kontaktstifts zu dem anderen Ende der Mantelhülse ohne großen Aufwand führbar. Durch den schrägwinkligen Verlauf wird insbesondere ein radialer Lichtaustritt aus dem Kontaktstift in einfacher Art und Weise gewährleistet. Besonders bevorzugt ist der Lichtdurchgangskanal als eine Kombination von einem Parallelverlauf und einem zumindest abschnittsweise schrägwinkligen Verlauf ausgebildet, sodass beispielsweise die Lichtquelle an einem Ende der Mantelhülse angeordnet ist, und das von ihr erzeugte Licht am anderen Ende oder im Bereich des Kontaktkolbens durch einen dort vorliegenden schrägwinkligen Verlauf des Lichtdurchgangskanals radial oder zumindest im Wesentlichen radial aus dem Kontaktstift ausgeleitet wird.

Weiterhin ist bevorzugt vorgesehen, dass die Lichtquelle in Abhängigkeit der Stellung des längsverschieblich geführten Kontaktkolbens angesteuert wird. Diese Ansteuerung erfolgt dabei beispielsweise durch die zuvor bereits erwähnte Steuerung, welche die Stellung des Kontaktkolbens in der Mantelhülse überwacht. Dazu ist der Kontaktstift beispielsweise als Schaltkontaktstift ausgebildet, der diskrete Schaltzustände oder einen kontinuierlich veränderlichen Schaltzustand aufweist. Alternativ wird die Lichtquelle direkt in Abhängigkeit der Stellung des Kontaktkolbens angesteuert, indem beispielsweise der Strompfad zur Energieversorgung der Lichtquelle durch die Stellung des Kontaktkolbens beeinflusst wird. Dies kann beispielsweise dadurch erreicht werden, dass der Kontaktstift ein elektrisches Kontaktelement aufweist, das im elektrischen Berührungskontakt mit einer Stromschiene an der Mantelhülse des Kontaktstifts steht, wobei die Stromschiene als Widerstandsschiene mit einem sich über Längserstreckung verändernden Widerstand ausgebildet ist, und wobei die Lichtquelle elektrisch mit dem Kontaktelement und der Stromschiene verbunden ist, sodass eine direkte Beeinflussung des von der Lichtquelle erzeugten Lichts durch die aktuelle Stellung des Kontaktkolbens erfolgt. Auch kann die Steuerung der Lichtquelle rein optisch erfolgen, wie zuvor bereits erwähnt, indem beispielsweise beim Verschieben beziehungsweise durch das Verschieben des Kontaktkolbens eine oder mehrere Lichtaustrittsöffnungen und/oder eine Lichteintrittsöffnung des Lichtdurchgangskanals verschlossen oder freigegeben werden.

Weiterhin ist vorzugsweise vorgesehen, dass die Lichtquelle auswechselbar im oder am Kontaktstift oder der Montagehülse angeordnet ist. Dadurch kann die Lichtquelle bei Bedarf, insbesondere zur Wartungszwecken ausgetauscht werden. Die Lebensdauer des Kontaktstifts wird dadurch insgesamt erhöht.

Die erfindungsgemäße Kontaktstiftanordnung mit den Merkmalen des Anspruchs 15 zeichnet sich dadurch aus, dass sie mindestens eine im Inneren der Montagehülse angeordnete Lichtquelle, die zumindest ein elektrisch aktivierbares Leuchtmittel aufweist, wobei der Kontaktstift mindestens ein mit Lichteintritts- und Lichtaustrittsöffnung versehenen Lichtdurchgangskanal für von der Lichtquelle ausgesandtes Licht besitzt. Die erfindungsgemäße Kontaktstiftanordnung sieht also vor, dass die Lichtquelle nicht direkt in dem Kontaktstift, sondern in der den Kontaktstift aufnehmenden Montagehülse angeordnet ist. Montagehülsen sind grundsätzlich bekannt und erleichtern das Austauschen des Kontaktstifts, wenn dieser kritische Verschleißerscheinungen aufweist. Die Lichtquelle selbst ist keinem mechanischen Verschleiß ausgesetzt, im Gegensatz zu dem Kontaktstift, und weist daher von Natur aus eine höhere Lebensdauer als der Kontaktstift auf. Dadurch, dass die Lichtquelle in der Montagehülse angeordnet ist, ergibt sich der Vorteil, dass bei einem Austausch des Kontaktstifts die Lichtquelle nicht mitausgetauscht wird, sodass sich Kostenvorteile durch die längere Nutzung der Lichtquelle ergeben. Darüber hinaus ergibt sich hierbei eine einfache elektrische Kontaktierung der Lichtquelle.

Vorzugsweise ist die Lichtquelle wie die zuvor beschriebene Lichtquelle des erfindungsgemäßen Kontaktstifts ausgebildet. Es ergeben sich dadurch die bereits genannten Vorteile. Weitere Vorteile und Merkmale und Merkmalskombinationen ergeben sich insbesondere aus dem zuvor Beschriebenen sowie aus den Zeichnungen.

Im Folgenden soll die Erfindung anhand der Zeichnung näher erörtert werden. Dazu zeigen
- Figuren 1 A bis C: eine vorteilhafte Kontaktstiftanordnung gemäß einem ersten Ausführungsbeispiel,
- Figuren 2 A bis E: die Kontaktstiftanordnung gemäß einem zweiten Ausführungsbeispiel.
- Figuren 3 A bis C: die Kontaktstiftanordnung gemäß einem dritten Ausführungsbeispiel,
- Figuren 4 A bis C: die Kontaktstiftanordnung gemäß einem vierten Ausführungsbeispiel,
- Figuren 5 A bis E: die Kontaktstiftanordnung gemäß einem fünften Ausführungsbeispiel,
- Figur 6: einen vorteilhaften Kontaktstift gemäß einem sechsten Ausführungsbeispiel,
- Figuren 7 A bis D: den Kontaktstift gemäß einem siebten Ausführungsbeispiel,
- Figur 8: den Kontaktstift gemäß einem achten Ausführungsbeispiel,
- Figur 9: den Kontaktstift gemäß einem neunten Ausführungsbeispiel,
- Figur 10: den Kontaktstift gemäß einem zehnten Ausführungsbeispiel,
- Figur 11: den Kontaktstift gemäß einem elften Ausführungsbeispiel,
- Figur 12: den Kontaktstift gemäß einem zwölften Ausführungsbeispiel,
- Figur 13: den Kontaktstift gemäß einem dreizehnten Ausführungsbeispiel,
- Figur 14: eine Montagehülse der Kontaktstiftanordnung gemäß einem vierzehnten Ausführungsbeispiel.
- Figur 15: die Montagehülse gemäß einem fünfzehnten Ausführungsbeispiel.
- Figur 16: die Kontaktstiftanordnung gemäß einem sechzehnten Ausführungsbeispiel,
- Figuren 17 A bis C: den Kontaktstift gemäß einem siebzehnten Ausführungsbeispiel,
- Figuren 18 A bis C: den Kontaktstift gemäß einem achtzehnten Ausführungsbeispiel, und
- Figur 19: eine vorteilhafte Lichtquelle.

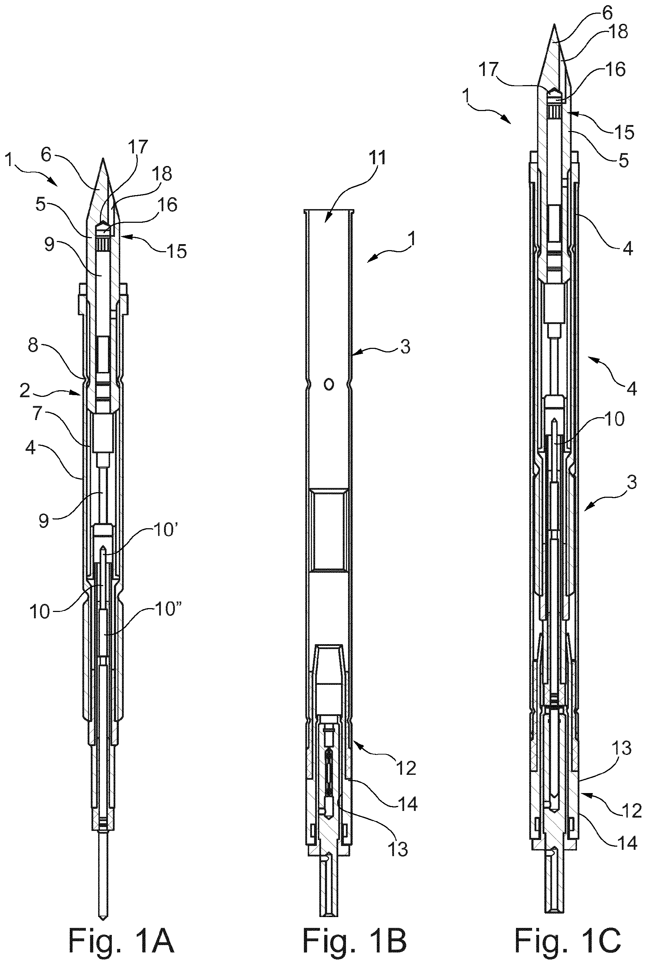

Figuren 1A bis C zeigen eine vorteilhafte Kontaktstiftanordnung 1 mit einem Kontaktstift 2, der in Figur 1A in einer Längsschnittdarstellung gezeigt ist, und mit einer Montagehülse 3, die in Figur 1B in einer Längsschnittdarstellung gezeigt ist. Die Kontaktstiftanordnung ist zusammengesetzt in Figur 1C, ebenfalls in einer Längsschnittdarstellung, gezeigt.

Der Kontaktstift 2 ist gemäß dem vorliegenden Ausführungsbeispiel als Schaltkontaktstift ausgebildet. Dabei weist der Kontaktstift 2 eine Mantelhülse 4 auf, in welcher ein Kontaktkolben 5 längsverschieblich gelagert ist. Dabei weist der Kontaktkolben 5 eine Kontaktspitze 6 auf, die aus der Mantelhülse 4 stirnseitig hervorragt und vorliegend einstückig mit dem Kontaktkolben 5 ausgebildet ist. Dazu ist ein Federelement 7 in der Mantelhülse 4 angeordnet, welches sich einendig an der Mantelhülse 4 und anderendig an dem Kontaktkolben 5 abstützt, um diesen aus der Mantelhülse 4 herauszudrängen. Durch eine in der Mantelhülse 4 ausgebildete Durchmesserverjüngung 8 ist der Kontaktkolben 5 formschlüssig daran gehindert, vollständig aus der Mantelhülse 4 herauszutreten.

Der Kontaktkolben 5 weist dabei außerdem einen an dem von der Kontaktspitze 6 abgewandten Ende vorstehenden Schaltkolben 9 auf, der sich axial in der Verlängerung des Kontaktkolbens 5 in die Montagehülse hineinerstreckt und fest mit dem Kontaktkolben 5 verbunden ist. Das Federelement 7 ist insbesondere als Schraubenfeder ausgebildet, die koaxial zu dem Schaltkolben 9 angeordnet ist, sodass sich der Kontaktkolben 9 in die Schraubenfeder beziehungsweise mittig durch die Schraubenfeder erstreckt.

Weiterhin ist in der Mantelhülse 4 ein Schaltpin 10 angeordnet, der sich durch das von dem Schaltkolben 5 abgewandte Ende der Mantelhülse 4 hindurch erstreckt und fest in der Mantelhülse 4 gehalten ist.

Der Schaltpin 10 ist, wie insbesondere der Schaltkolben 9 auch, elektrisch leitfähig ausgebildet und endet im unbelasteten Zustand des Kontaktkolbens 5 beabstandet zu dem Schaltkolben 9 in der Mantelhülse 4. Erst dann, wenn mit dem Kontaktstift 2 ein zu prüfender Kontakt kontaktiert wird und dadurch der Kontaktkolben 5 in die Mantelhülse 4 einfedert, gelangt der Schaltpin 10 in Berührungskontakt mit dem Schaltkolben 9, wodurch eine elektrische Verbindung von dem Kontaktkolben 5 zu dem Schaltpin 10 hergestellt wird. Alternativ ist vorgesehen, dass der Schaltkolben 9 und der Kontaktkolben 5 selbst elektrisch nicht leitfähig ausgebildet sind, wobei stattdessen der Schaltpin 10 einen verlagerbaren Kontaktpin 10' und einen fest in der Mantelhülse 4 angeordneten Pinzylinder 10" aufweist, wobei in Abhängigkeit von der Schiebestellung des Kontaktpins 10' ein elektrischer Kontakt in dem Schaltpin 10 hergestellt wird, beispielsweise dann, wenn der Kontaktpin 10' ausreichend weit in den Kontaktzylinder 10" eingeschoben wurde.

Die in Figur 1B gezeigte Montagehülse 3 bietet den Vorteil einer einfachen Montage und insbesondere eines einfachen Austauschs des Kontaktstifts 2, wenn beispielsweise der Kontaktkolben 5, insbesondere die Kontaktspitze 6, Verschleißerscheinungen aufweist. Die Montagehülse 3 wird vor dem Kontaktstift in der Bohrung einer Testplatte montiert und der Kontaktstift 2 anschließend axial eingeschoben. Vorliegend weist die Montagehülse 3 eine Einstecköffnung 11 auf, durch welche der Kontaktstift 2 in die Montagehülse 3 einführbar ist. Um eine sichere Arretierung des Kontaktstifts 2 in der Montagehülse 3 zu gewährleisten, meist die Mantelhülse 4 zweckmäßigerweise ein Außengewinde auf, dass mit einem Innengewinde der Montagehülse 3 zusammenwirkt, sodass der Kontaktstift 2 in die Montagehülse 3 einschraubbar ist. Alternativ kann als Befestigung auch eine Presspassung, ein Bajonettverschluss oder dergleichen vorgesehen sein. An dem der Einstecköffnung 11 abgewandten Ende trägt die Montagehülse 3 eine elektrische Schnittstelle 12, mittels welcher die Kontaktstiftanordnung 1 elektrisch mit einer externen Einrichtung, wie einer Testeinrichtung, verbindbar ist. Die Schnittstelle 12 ist dabei als Steckschnittstelle ausgebildet und weist eine Aufnahme 13 auf, die vorliegend als Klemmaufnahme ausgebildet ist, und in welcher dass von dem Kontaktstift 2 vorstehende frei Ende des Schaltpins 10 bei der Montage des Kontaktstifts 2 der Montagehülse 3 einführbar und dadurch per Berührungskontakt elektrisch kontaktierbar ist, wie in Figur 1C gezeigt. Die Schnittstelle 12 kann in die Montagehülse 3 integriert ausgebildet sein, oder wie in Figur 1B und 1C gemäß dem folgenden Ausführungsbeispiel gezeigt, durch ein auf das freie Ende der Montagehülse 3 aufgesetztes, insbesondere aufgeschraubtes oder eingeschraubtes Anschlussstück 14 gebildet sein.

Insoweit entspricht die Kontaktstiftanordnung 1 im Wesentlichen dem eines herkömmlichen Schaltkontaktstifts mit Montagehülse.

Vorteilhafterweise weist die vorliegende Kontaktstiftanordnung 1 eine integrierte Lichtquelle 15 auf. Die Lichtquelle 15 weist vorliegend elektrisch aktivierbares Leuchtmittel 16 auf, das vorliegend als Leuchtdiode (LED) ausgebildet ist. Gemäß dem vorliegenden Ausführungsbeispiel ist dabei das Leuchtmittel 16 in dem Kontaktkolben 5 angeordnet.

Das Leuchtmittel 16 ist dabei in einem Hohlraum 17 zwischen dem der Kontaktspitze 6 zugewandten Ende des Schaltkolbens 9, der sich in den Kontaktkolben 5 hineinerstreckt, und der Kontaktspitze an dem Kontaktkolben 9 stirnseitig angeordnet. Dem Hohlraum 17 ist eine Lichtaustrittsöffnung 18 zugeordnet, die exzentrisch in dem Kontaktkolben 5 im Bereich der Kontaktspitze 6 ausgebildet ist. Die Lichtaustrittsöffnung 18 ist als sich axial erstreckende beziehungsweise axial ausgerichtete Bohrung ausgebildet, weswegen diese Lichtaustrittsöffnung 18 als axiale Lichtaustrittsöffnung 18 bezeichnet wird.

Zum Betreiben der Lichtquelle 15 ist das Leuchtmittel 16 entweder in einen Test-Strompfad der Kontaktstiftanordnung 1 eingebunden, und dazu beispielsweise elektrisch mit dem Schaltkolben 9 verbunden, sodass sobald der Schaltkontakt hergestellt wurde, auch das Leuchtmittel 16 aktiviert wird. Oder dem Leuchtmittel 16 ist ein separater Licht-Strompfad zugeordnet und in dem Kontaktstift 2 ausgebildet, beispielsweise parallel zu dem Schaltkolben 9. Zweckmäßigerweise weist die Schnittstelle 12 der Montagehülse 3 dann einen zusätzlichen Kontaktanschluss für der Strompfad des Leuchtmittels 16 auf.

Dadurch, dass das Leuchtmittel 16 direkt in den Kontaktstift 2 beziehungsweise die Kontaktstiftanordnung 1 integriert ist, ist im gleichen, lateral begrenzten Bauraum eines Prüfadapters, in welchem eine Vielzahl der Kontaktstiftanordnungen 1 angeordnet werden, eine Beleuchtungsfunktion realisiert. Dadurch, dass das elektrisch aktivierbare Leuchtmittel 16 direkt in dem Kontaktstift 2 angeordnet ist, wird dies Bauraumsparend und kostengünstig realisiert. Mittels der Lichtquelle 15 ist an dem dem Testobjekt zugewandten Ende des Kontaktstifts 2 ein visuelles Signal anzeigbar, indem Leuchtmittel 16 aktiviert wird. Dies kann beispielsweise als Anweisung zur Durchführung einer dem Beleuchtungszustand entsprechenden Tätigkeit genutzt werden. Die elektrische Energie für die Beleuchtung wird extern bereitgestellt und über einen der genannten Strompfade dem Leuchtmittel 16 zur Verfügung gestellt. Insbesondere bei der Variante, bei welcher dem Leuchtmittel 16 ein eigener Licht-Strompfad zugeordnet ist, ist eine Aktivierung des Leuchtmittels 16 unabhängig vom Schaltzustand des Kontaktstifts 2 beziehungsweise vom Betätigungszustand möglich.

Die Beleuchtung kann durch externe oder interne Verschaltungen/Befehle in verschiedene Zustände gebracht werden, wie beispielsweise eingeschaltet, kontinuierlich oder blinkend und/oder farblich wechselnd, ausgeschaltet, oder, wenn mehr als eine Leuchtmittel 16 vorhanden ist, eine Kombination aus eingeschaltet und ausgeschaltet. Die gewünschten Zustände werden zweckmäßigerweise zuvor vom Anwender in einer Prüfroutine festgelegt. Sie können in einem starren Ablauf folgend, um beispielsweise eine Montageanweisung zu realisieren, und/oder durch Ereignisse im Prüfablauf bedingt sein, also in Abhängigkeit von Testergebnissen erfolgen.

Das Leuchtmittel 16 ist zweckmäßigerweise dazu ausgebildet, Licht im sichtbaren Bereich auszustrahlen. Dazu ist das Leuchtmittel 16 bevorzugt als Leuchtdiode (LED), als SMD-Chip (vorzugsweise axial oder seitlich abstrahlend), als in klassischer Rundform (Nacktchip oder vergossen), einfarbig oder mehrfarbig ausgebildet. Wie bereits erwähnt, können auch mehrere Leuchtmittel 16 im Kontaktstift 2 angeordnet sein. Alternativ zur Ausbildung als LED ist auch denkbar, das Leuchtmittel 16 als Laser, insbesondere in Form eines SMD-Chips, auszubilden. Grundsätzlich ist auch denkbar, das Leuchtmittel 16 derart auszubilden, dass es Licht in einem für den Menschen nicht sichtbaren Spektrum ausstrahlt, wobei dann zum Empfangen des Lichtsignals ein entsprechender Sensor vorhanden ist, um das Lichtsignal auswerten zu können.

Bei dem in Figur 1 gezeigten Ausführungsbeispiel sind sowohl die Kontaktspitze 6 als auch die Beleuchtung beziehungsweise das Leuchtmittel 16 dem Testobjekt und dem Operator der die Kontaktstiftanordnung 1 aufweisenden Testanordnung zugewandt. Der Lichtaustritt befindet sich aufgrund der Lichtaustrittsöffnung 18 am Kontaktkopf 6. Ist das Leuchtmittel 16 nicht indirekt der Aufnahme 17 beziehungsweise dem der Lichtaustrittsöffnung 18 zugeordnet, wie im ersten Ausführungsbeispiel gezeigt, so ist in dem Kontaktstift oder der Kontaktstiftanordnung 1 eine Strahlenführen mit wenigstens einem Lichtdurchgangskanal vorgesehen, der das Licht von dem Leuchtmittel 16 bis zu der Lichtaustrittsöffnung 18 führt.

Verschiedene Varianten der vorteilhaften Kontaktstiftanordnung 1 werden mit Bezug auf die weiteren Figuren im Folgenden erläutert. Aus dem ersten Ausführungsbeispiel bereits bekannte Elemente sind mit den gleichen Bezugszeichen versehen, sodass insofern auf die vorhergehende Beschreibung verwiesen wird. Es soll im Wesentlichen nur auf die Unterschiede eingegangen werden.

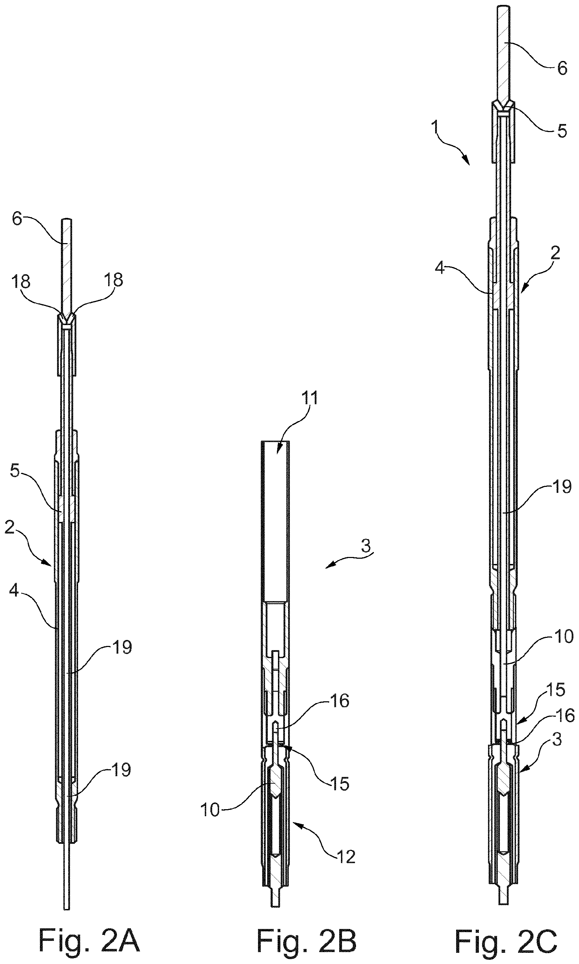

Figuren 2A bis E zeigen ein zweites Ausführungsbeispiel der Kontaktstiftanordnung 1, bei welcher der Kontaktstift 2 als Verraststift ausgebildet ist, und bei welchem die Lichtquelle 15 nicht im Kontaktkolben 5, sondern in der Montagehülse 3 angeordnet ist.

Gemäß Figur 2A zeigt dazu den Kontaktstift 2 in einem Längsschnittdarstellung. Figur 2B zeigt die Montagehülse 3 und die Figur 2 C die zusammengesetzte Kontaktstiftanordnung 1 jeweils in einer Längsschnittdarstellung. In der Mantelhülse 4 ist der Kontaktkolben 5 verschiebbar gelagert, wobei sich der Kontaktkolben 5 im Vergleich zum vorhergehenden Ausführungsbeispiel weiter in die Mantelhülse 4 hinein erstreckt. Auch hier wirkt dem Kontaktkolben eine Schraubenfeder entgegen. Der Kontaktkolben 5 ragt dabei auf der Kontaktspitze 6 abgewandten Seite aus der Mantelhülse 4 heraus. Der Kontaktkolben 5 ist hohlzylinderförmig ausgebildet und die Kolbenspitze 6 wird hierbei durch ein auf den hohlzylinderförmigen Kontaktkolben 5 aufgesetztes Element gebildet. Dadurch, dass der Kontaktkolben 5 hohlzylinderförmig ausgebildet ist, bildet er einen zentralen Lichtdurchgangskanal 19, der sich von dem der Montagehülse 3 zugewandten Ende bis zu der aufgesetzten Kontaktspitze 6 erstreckt.

Die Montagehülse 3 weist an der Schnittstelle 12 die Lichtquelle 15 auf, die beispielsweise in den dort vorgesehenen Schaltpin 10 integriert ist. Dabei ist die Lichtquelle dem Kontaktstift 2 derart zugeordnet, dass das von ihr erzeugte Licht in den Lichtdurchgangskanal 19 tritt oder treten kann. Die Kontaktspitze 6 weist gemäß dem vorliegenden Ausführungsbeispiel zwei Lichtaustrittsöffnungen 18 auf, die dem der Kontaktspitze 6 zugewandten Ende des Kontaktkolbens 5 zugeordnet sind, um das Licht, das durch den Lichtdurchgangskanal 19 gelangt, nach außen zu leiten. Die Lichtaustrittsöffnungen 18 sind dabei schrägwinklig zu einer Mittellängsachse des Kontaktstifts 2 ausgebildet, sodass das Licht sowohl axial als auch radial aus dem Kontaktstift 2 austritt.

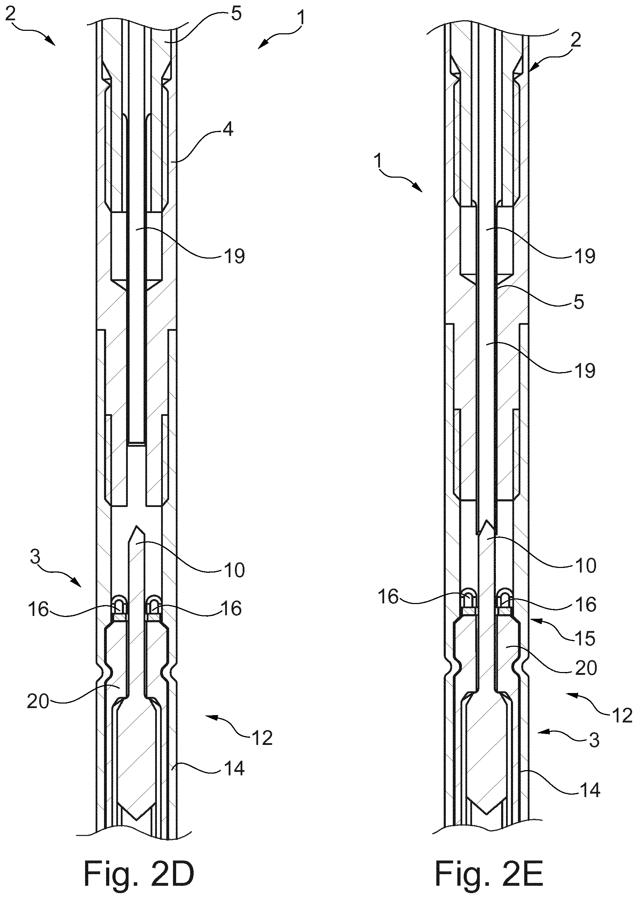

Figuren 2 D und 2 E zeigen jeweils eine vergrößerte Darstellung der Kontaktstiftanordnung 1 gemäß dem zweiten Ausführungsbeispiel im Bereich der Lichtquelle 15.

Gezeigt ist, dass hier die Lichtquelle 15 mehrere, vorliegend insbesondere 3 Leuchtmittel 16 auf weist, die an einer in der Montagehülse 3 angeordneten hohlzylinderförmigen Halterung 20 stirnseitig angeordnet sind. Die Halterung 20 dient gleichzeitig zur Führung und Lagerung des Schaltpins 10. Die Leuchtmittel 16 sind dabei benachbart zu dem Schaltpin 10 zu diesem umgebend angeordnet. Figur 2 D zeigt dabei den unbetätigten Zustand des Kontaktstifts 2 und Figur 2 E den betätigten, bei welchem der Kontaktkolben 5 in Richtung des Schaltpins 10 verlagert wurde, bis er im Berührungskontakt mit diesem steht. Der Schaltpin 10 und der Kontaktkolben 5 sind dabei derart ausgebildet, dass der Kontaktkolben 5 auf den Kontaktschaltpin 10 aufgeschoben werden kann, bis der Schaltpin 10 den im dem Kontaktkolben 5 ausgebildeten Lichtdurchgangskanal 19 vollständig verschließt. Bei betätigten Kontaktstift 2 ist dabei der Lichtdurchgang zu den Lichtaustrittsöffnungen 18 versperrt. Dadurch ist eine Prüfung der Funktionsfähigkeit der Kontaktstiftanordnung 1 einfach möglich.

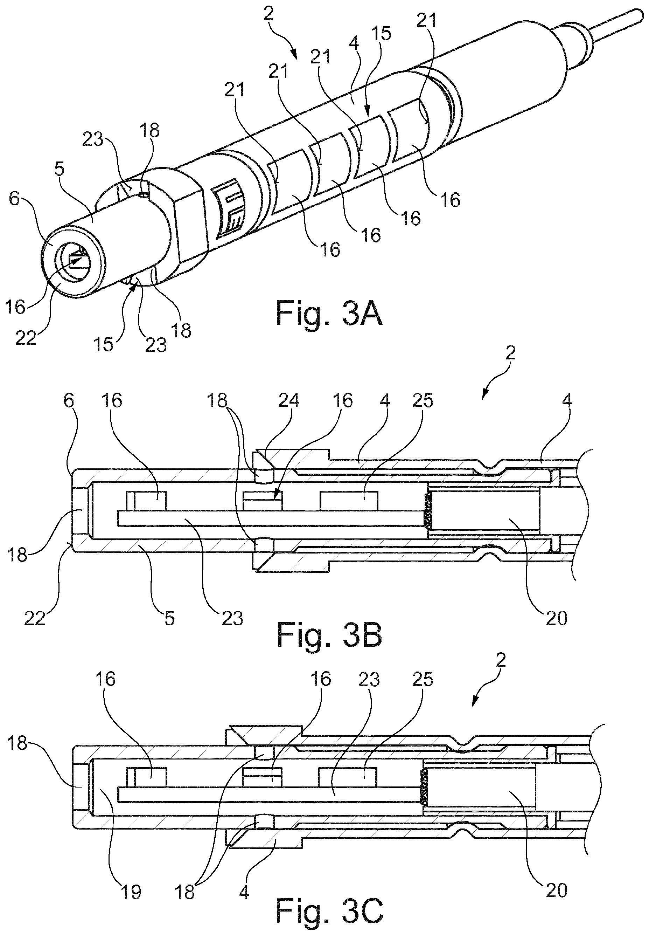

Figuren 3A bis C zeigen ein drittes Ausführungsbeispiel, bei welchem der dargestellte Kontaktstift 2 mit oder ohne Montagehülse 3 verwendet werden kann.

Im Unterschied zu den vorhergehenden Ausführungsbeispielen ist hierbei vorgesehen, dass der Kontaktstift 2 mehrere Leuchtmittel 16 aufweist. Dabei ist vorliegend vorgesehen, dass einige der Leuchtmittel 16 in Mantelwandöffnungen 21 der Mantelhülse 4 angeordnet sind und somit keine zusätzlichen Lichtdurchgangskanal oder eine zusätzliche Lichtaustrittsöffnung benötigen. Vorliegend sind die Leuchtmittel axial nebeneinanderliegend angeordnet und sind insbesondere dazu ausgebildet, unterschiedliche Farben zu erzeugen, sodass das erzeugte Licht seitlich, lateral beziehungsweise radial von dem Kontaktstift 2 ausgestrahlt wird. Weiterhin ist in dem Kontaktstift 2, vorliegend in dem Kontaktkolben 5, ein weiteres Leuchtmittel 16 angeordnet, dessen Licht durch seitliche Lichtaustrittsöffnungen 18 aus dem Kontaktkolben 5 austreten kann.

Hierzu zeigt Figur 3B eine Längsschnittdarstellung durch den Kontaktstift 2 im Bereich des Kontaktkolbens 5. Die seitlichen Lichtaustrittsöffnungen 18 im Kontaktkolben 5 sind derart im Kontaktkolben 5 angeordnet, dass sie von der Mantelhülse 4 vorstehen, wenn der Kontaktstift 2 nicht betätigt ist. Sobald der Kontaktkolben 5 in die Mantelhülse 4 einfedert, werden die Lichtaustrittsöffnungen 18 durch die Montagehülse überdeckt und das Licht des innenliegenden Leuchtmittels 16 kann nicht mehr durch die Lichtaustrittsöffnungen 18 austreten, wie in Figur 3C gezeigt.

An der Kontaktspitze 6, die eine Kontaktierungsfläche 22 aufweist, welche im Betrieb das zu prüfende Testobjekt berührungskontaktiert, ist vorliegend eine weitere Lichtaustrittsöffnung 18 ausgebildet, die in diesem Fall nicht seitlich beziehungsweise radial, sondern axial ausgerichtet ist, sodass das Licht von dem innenliegenden Leuchtelement 16 oder einem weiteren der Kontaktspitze 6 zugeordneten Leuchtelement 16 axial aus dem Kontaktstift 2 austreten kann.

Die Lcuchtmittcl 16, die in dem Kontaktkolbcn 5 angeordnet sind, sind vortcilhaftcrwcisc auf einer Leitplatte 23 angeordnet, die fest in dem Kontaktkolben 5 gehalten ist. Die Leiterplatte 23 trägt dabei optional außerdem eine Elektronikeinheit 30, die beispielsweise die Ansteuerung der Leuchtmittel 16 auf der Leiterplatte 23 und optional auch die Ansteuerung der Leuchtmittel 16 in der Mantelwand der Mantelhülse 4 übernimmt.

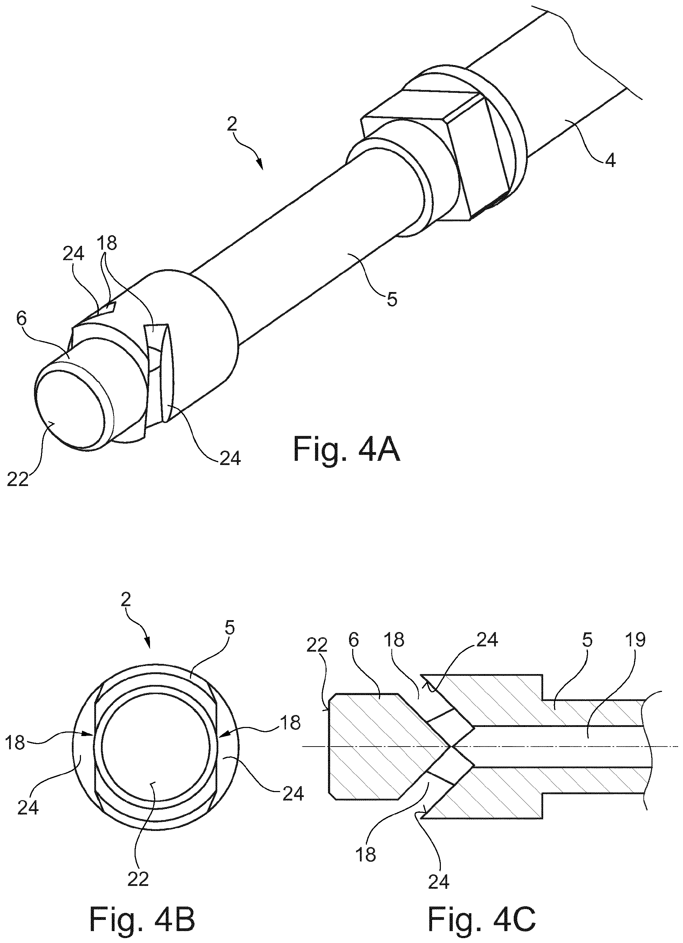

Figuren 4A bis 4C zeigen ein weiteres Ausführungsbeispiel des Kontaktstifts 4, wobei Figur 4A eine perspektivische Teilansicht, Figur 4B eine axiale Draufsicht und Figur 4C eine Längsschnittdarstellung zeigen.

Ähnlich wie bei dem zweiten Ausführungsbeispiel ist hier der Kontaktkolben 5 hohlzylinderförmig ausgebildet, sodass er einen Lichtdurchgangskanal 19 aufweist, der bis zu den Lichtaustrittsöffnungen 18 führt, die im Bereich der Kontaktspitze 6 des Kontaktkolbens schrägwinklig aus dem Kontaktkolben 5 austreten, wie am Besten in Figur 4 C ersichtlich ist.

Vorteilhafterweise ist dabei vorgesehen, dass der Kontaktkolben 5 auf der der Kontaktspitze 6 zugewandten Seite schmaler ausgebildet ist als auf der anderen Seite der Lichtaustrittsöffnungen 18, sodass ein radialer Überstand des Kontaktkolbens 5 unterhalb der Kontaktspitze 6 beziehungsweise der Kontaktierungsfläche 22 entsteht, wodurch sich an dem Kontaktkolben 5 eine radial überstehende Reflektionsfläche 24 ausbildet, welche das von dem Leuchtmittel 16 erzeugte Licht vorteilhaft in die Umgebung reflektiert. Insbesondere ist dadurch eine großflächige Reflektion gewährleistet, welche das Erkennen der Beleuchtung für den Operator erleichtert. In dem vorliegenden Ausführungsbeispiel ist der Kontaktstift 2 außerdem als einfacher Federkontaktstift, insbesondere ohne Schaltfunktion, ausgebildet.

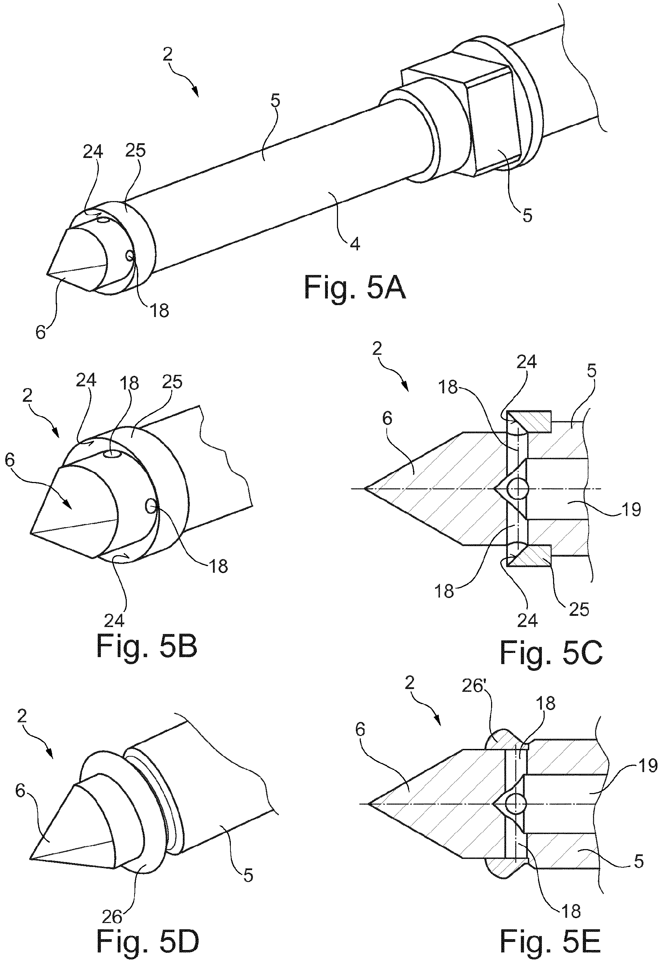

Figuren 5A bis E zeigen ein fünftes Ausführungsbeispiel des Kontaktstifts 2, dass sich von dem vorhergehenden Ausführungsbeispiel im wesentliche dadurch unterscheidet, dass die Kontaktspitze 6 kegelförmig spitz zulaufend ausgebildet ist, und das unterhalb der Kegelform mehrere seitliche beziehungsweise laterale Lichtaustrittsöffnungen 18 ausgebildet sind. Figur 5A zeigt dabei den Kontaktstift in einer perspektivischen Darstellung, Figur 5B in einer vergrößerten Detaildarstellung und Figur 5C in einer Längsschnittdarstellung.

Die Mantelhülse 4 des Kontaktstifts 2 weist einen Reflektionsring 25 auf, der entweder einstückig mit der Mantelhülse 4 ausgebildet oder, wie im vorliegenden Ausführungsbeispiel gezeigt, auf die Mantelhülse 4 aufgeschoben ist. Der Reflektionsring 25 weist die vorliegend kegel- oder keilförmige Reflektionsfläche 24 auf, die in etwa 45° zur Längsmittelachse (gestrichelt dargestellt) des Kontaktstifts 2 ausgerichtet ist und in Richtung der Mantelhülse 4, also von der Kontaktspitze 6 weg, spitz zuläuft. Auch hier hilft die vorteilhafte Reflektionsfläche 24, es dem Operateur die Beleuchtung des Kontaktstifts 2 zu erkennen. Vorzugsweise ist die Reflektionsfläche 24 als durchgehende Ringfläche ausgebildet, sodass der Beleuchtung besonders gut ringförmig erkennbar ist. Durch die mehreren Lichtaustrittsöffnungen 18 ist dabei gewährleistet, dass die Reflektionsfläche 24 im Wesentlichen gleichmäßig ausgeleuchtet ist, wenn das Leuchtmittel 16 im Inneren des Kontaktstifts 2 aktiviert ist.

Figuren 5D und E zeigen eine Variante des fünften Ausführungsbeispiels, bei welcher die Lichtaustrittsöffnungen 18 durch einen transparenten Lichtstreuring 26' mit innenliegender Reflektionsfläche bedeckt sind. Der Streuring 26' wird somit von innen beleuchtet, weil er die Lichtaustrittsöffnungen 18 überdeckt, wie insbesondere in Figur 5 E gezeigt und streut das Licht in die Umgebung. Auch hierdurch wird der Betrieb von dem Operateur vereinfacht.

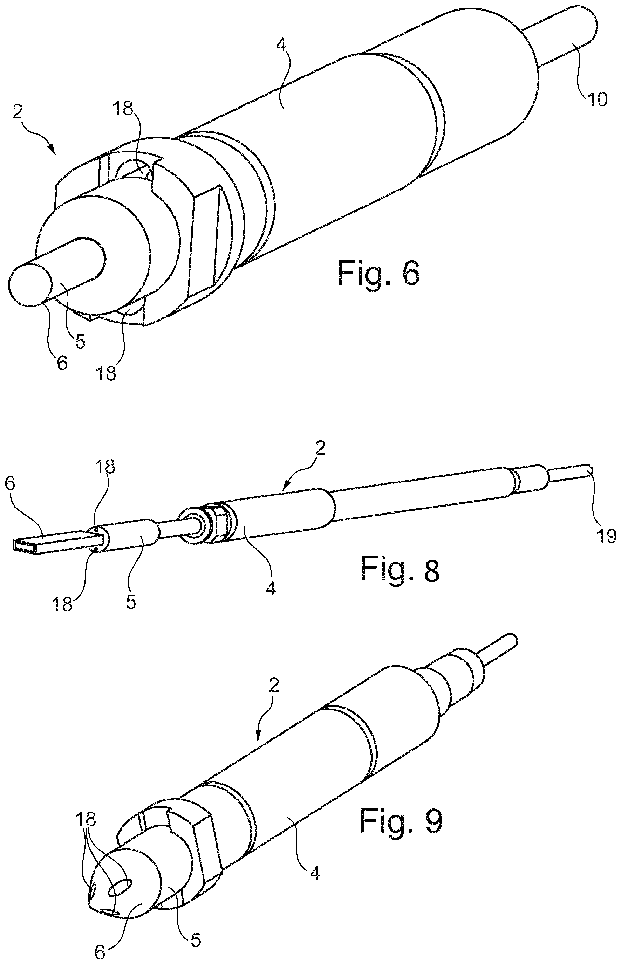

Figur 6 zeigt ein weiteres Ausführungsbeispiel des Kontaktstifts 2 in einer perspektivischen Darstellung, wobei gemäß diesem Ausführungsbeispiel die Mantelhülse 4 selbst zwei axiale Lichtaustrittsöffnungen 18 an ihrem den Kontaktkolben 5 beziehungsweise der Kontaktspitze 6 zugewandten Ende aufweist, sodass der Kontaktkolben 5 mitbeleuchtet wird, wenn die Leuchtmittel oder das Leuchtmittel aktiviert sind/ist.

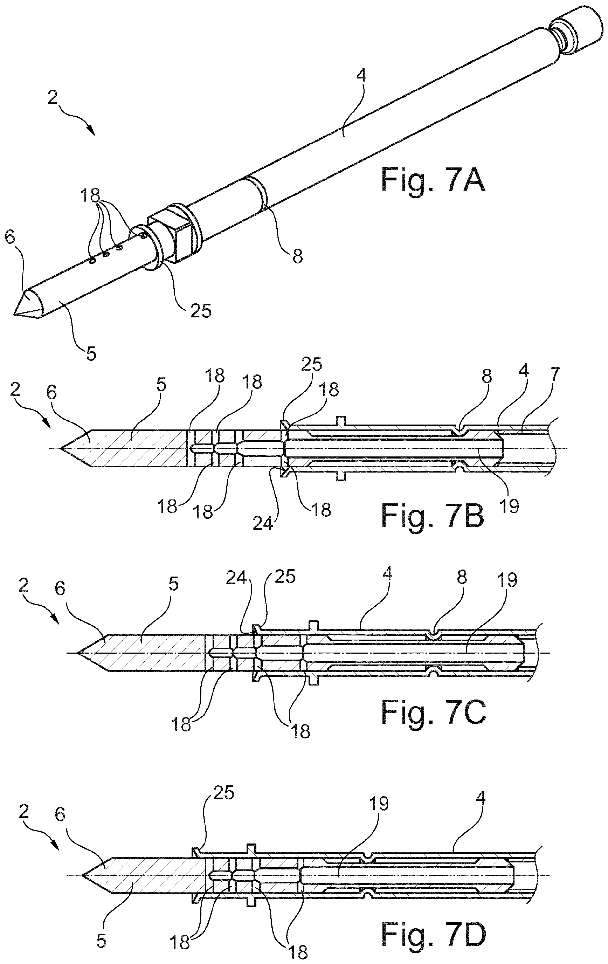

Figuren 7A bis 7D zeigen ein weiteres Ausführungsbeispiel des Kontaktstifts 2 der Kontaktstiftanordnung 1. Auch in diesem Ausführungsbeispiel kann der Kontaktstift 2 mit oder ohne Montagehülse verwendet werden. Im Unterschied zu dem fünften Ausführungsbeispiel gemäß Figur 5 ist hierbei vorgesehen, dass der Kontaktkolben 5 mehrere axial beabstandet zueinander in Reihe angeordnete Lichtaustrittsöffnungen 18 aufweist, durch welche das in den Lichtdurchgangskanal 19 eingebrachte Licht aus dem Kontaktstift 2 lateral/seitlich beziehungswiese radial austreten kann. Figur 7A zeigt dazu den Kontaktstift 2 in einer perspektivischen Darstellung und Figuren 7B und 7D zeigen den Kontaktstift 2 in einer Längsschnittdarstellung jeweils in unterschiedlichen Betriebsstellungen, bei welchen der Kontaktkolben 5 unterschiedlich weit in die Mantelhülse 4 eingefedert ist.

Vorliegend weist der Kontaktkolben 5 insgesamt acht seitliche Lichtaustrittsöffnungen auf, von denen jeweils vier auf einer Seite des Kontaktkolbens 5 angeordnet sind. Die acht Lichtaustrittsöffnungen 18 sind durch vier Querbohrungen, die durch die Mittellängsachse des Kontaktkolbens 5 führen, wie in Figuren 7B bis 7D gezeigt, gefertigt. Befindet sich der Kontaktkolben 5 in der maximal durch das Federelement 7 ausgeschobenen Stellung, die durch die Führung 8 der Mantelhülse 4 definiert wird, liegen alle Lichtaustrittsöffnungen 18 im Wesentlichen außerhalb der Mantelhülse 4. Die der Mantelhülse 4 am nächsten liegende Lichtaustrittsöffnung 18 liegt dabei auf Höhe des Reflexionsrings 25, sodass das durch diese Lichtaustrittsöffnung 18 austretende Licht auf die Reflexionsfläche 24 trifft und in der zuvor beschriebenen Weise in die Umgebung reflektiert wird.

Wird der Kontaktkolben 5 im Betrieb durch die Berührungskontaktierung eines Objekts eingefädelt, so gelangt die der Mantelhülse 4 am nächsten liegende Lichtaustrittsöffnung 18 in die Mantelhülse 4 hinein, sodass diese Lichtaustrittsöffnung 18 verschlossen wird und das Licht nur durch die drei außerhalb der Mantelhülse 4 verbleibenden Lichtaustrittsöffnungen 18 austreten kann, wie in Figur 7C gezeigt. Wird der Kontaktkolben 5 weiter eingefedert, wie beispielsweise in Figur 7D gezeigt, werden alle Lichtaustrittsöffnungen 18 des Kontaktkolbens 5 durch die Mantelhülse 4 verschlossen, sodass die Beleuchtung des Kontaktstifts 2 in diesem Fall komplett abgeschaltet ist.

Durch die mehrere Lichtaustrittsöffnungen 18 kann der Operator in diesem Fall schnell erkennen, wieweit der Kontaktkolben 5 einfedert und ob er beispielsweise erwartungsgemäß weit einfedert, oder aufgrund eines zu geringen oder zu weiten Einfederns auf ein mechanisches Problem des Kontaktkolbens und/oder des Testobjekts geschlossen werden muss.

Figur 8 zeigt ein achtes Ausführungsbeispiel des Kontaktstifts 2, bei welchem die Lichtquelle 15 in der Montagehülse 3 angeordnet ist, wie beispielsweise im zweiten Ausführungsbeispiel gezeigt. Der Kontaktkolben 5 weist vorliegend einen durchgehenden Lichtkanal 19 auf, der unterhalb der Kontaktspitze 6 des Kontaktkolbens 5 in zwei axial ausgerichteten Lichtaustrittsöffnungen 18 endet. Damit gleicht das achte Ausführungsbeispiel dem in Figur 3A gezeigten dritten Ausführungsbeispiel, wobei in diesem Fall auf die seitlichen Leuchtmittel 16 in der Mantelwand der Mantelhülse 4 verzichtet wird. Auch weisen in diesem Fall Austrittsöffnungen 18 keine schräggestellten Reflexionsflächen 24 auf.

Figur 9 zeigt ein weiteres Ausführungsbeispiel, das im Wesentlichen im ersten Ausführungsbeispiel von Figur 1 entspricht. Der Kontaktstift 2 weist dabei an der Kontaktspitze 6 des Kontaktkolbens 5 mehrere axial ausgerichtete Lichtaustrittsöffnungen 8 auf, die in dem Lichtdurchgangskanal 19, der durch den Kontaktstift 2 führt, münden. Im Unterschied zu dem ersten Ausführungsbeispiel ist hierbei, wie auch im achten Ausführungsbeispiel, die Lichtquelle 15 an der Montagehülse 3 beziehungsweise in der Montagehülse 3 angeordnet, und nicht wie im ersten Ausführungsbeispiel im Kontaktstift 2 selbst.

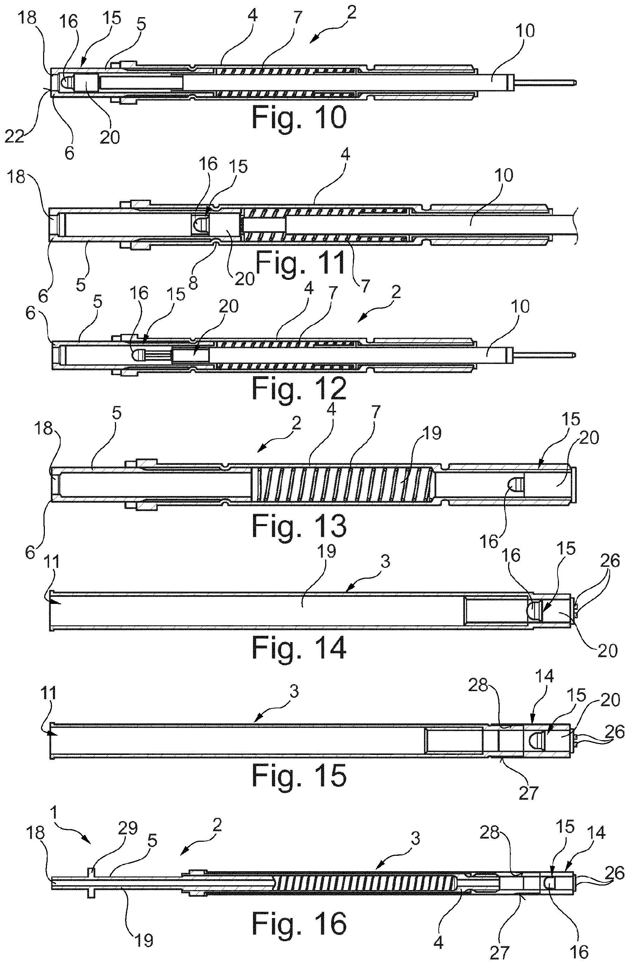

Figur 10 zeigt in einer Längsschnittdarstellung ein zehntes Ausführungsbeispiel, bei welchem der Kontaktstift 2 selbst die Lichtquelle 15 trägt, wie auch im ersten Ausführungsbeispiel. Im Unterschied zum ersten Ausführungsbeispiel ist dabei die Kontaktspitze 6 nicht spitz zulaufend, sondern als flache Kontaktspitze mit der Kontaktierungsfläche 22 ausgebildet, in welcher die axial Lichtaustrittsöffnung 18 ausgebildet ist, sodass das von dem Leuchtmittel 16 erzeugte Licht axial aus dem Kontaktstift 2 austritt. Das Leuchtmittel 16 ist dabei fest im Kontaktkolben 5 angeordnet, sodass das mit dem Kontaktkolben 5 in die Mantelhülse 4 einfedert. Dazu ist in dem Kontaktkolben 5 die Halterung 20 für das Leuchtmittel 16 fest angeordnet. In diesem Fall ist die Halterung 20 nicht hohlzylinderförmig, sondern vorzugsweise massiv ausgebildet, um einen festen Sitz des Leuchtmittels 16 zu gewährleisten. Selbstverständlich kann die Halterung 20 jedoch auch zu Materialeinsparung und Gewichtseinsparung zu hohlzylinderförmig ausgebildet sein. Weil das Licht von dem Leuchtmittel 16 jedoch zwischen der Halterung und der Lichtaustrittsöffnung 18 erzeugt wird, ist die hohle Ausbildung der Halterung 20 für den Lichtdurchtritt nicht notwendig.

Figur 11 zeigt ein elftes Ausführungsbeispiel des Kontaktstifts 2, das sich von dem vorhergehenden Ausführungsbeispiel dadurch unterscheidet, dass die Lichtquelle 15 an dem der Mantelhülse 4 zugewandten Ende des Kolbens 5 durch die Halterung 20 gelagert ist. Dadurch liegt die Lichtquelle 15 weiter hinten geschützt in dem Kontaktkolben 5.

Figur 12 zeigt ein zwölftes Ausführungsbeispiel, bei welchem der Kontaktstift 2 sich von dem vorhergehenden Ausführungsbeispiel dadurch unterscheidet, dass die Lichtquelle 15 nicht mit dem Kolben mitbewegt wird, sondern fest in der Mantelhülse 4 des Kontaktstifts 2 angeordnet ist. Dabei ist die Halterung 20 zwar innerhalb des Kontaktkolbens 5 angeordnet, jedoch fest mit der Mantelhülse 4, beispielsweise durch den fest in der Mantelhülse 4 angeordneten Anschlusspin 10 verbunden.

Figur 13 zeigt ein dreizehntes Ausführungsbeispiel des Kontaktstifts 2, dass sich von dem vorhergehenden Ausführungsbeispiel dadurch unterscheidet, dass die Leuchtquelle 15 in der Mantelhülse 4, und zwar an dem von dem Kontaktkolben 5 abgewandten Ende des Kontaktstifts 2 angeordnet ist. Dazu ist die Halterung 20 beispielsweise in das von dem Kontaktkolben 5 anbgewandte Ende der Montagehülse eingepresst und gegebenenfalls durch zusätzliche Befestigungsmittel darin gehalten. Die Mantelhülse 4 bildet dann in diesem Fall selbst den Lichtdurchgangskanal 19, der durch die Montagehülse und den hohlzylinderförmigen Kontaktkolben 5 bis zu der axialen Lichtaustrittsöffnung 18 an der Kontaktspitze 6 führt. Die Lichtquelle 15 ist damit im Bereich des Außengewindes der Mantelhülse 4 angeordnet, welches in das Innengewinde der Montagehülse einschraubbar ist.

Figur 14 zeigt ein vierzehntes Ausführungsbeispiel der Kontaktstiftanordnung 1, bei welcher die Lichtquelle gemäß dem zweiten Ausführungsbeispiel in der Montagehülse 3 angeordnet ist. Dabei ist die Lichtquelle an dem der Einstecköffnung 11 abgewandten Ende der Montagehülse 3 befestigt und kann dort über elektrischen Anschlussstellen 26 direkt elektrisch kontaktiert werden. Auch hier ist das Leuchtmittel 16 vorteilhafterweise als Leuchtdiode ausgebildet.

Figur 15 zeigt ein fünfzehntes Ausführungsbeispiel, bei welchem die Lichtquelle 15 ebenfalls der Montagehülse 3 zugeordnet ist. Im Unterschied zu dem vorhergehenden Ausführungsbeispiel ist hierbei jedoch vorgesehen, dass die Lichtquelle 15 in dem auf die Montagehülse 3 aufschraubbaren Anschlussstück 14 angeordnet ist. Dazu weist die Montagehülse 3 an ihrem von der Einstecköffnung 11 abgewandten Ende ein Außengewinde 27 auf, das mit einem Innengewinde 28 des Anschlussstücks 14 zusammenwirkt. Die Montagehülse 3 wird durch das Anschlussstück 14 vervollständigt beziehungsweise mit der Lichtquelle 15 ergänzt. Dabei ist vorliegend vorgesehen, dass das Anschlussstück 14 hohlzylinderförmig ausgebildet ist und im Innenraum die Lichtquelle 15 durch die Halterung 20 trägt.

Die Kontaktstiftanordnung 1 ist auf diese Weise besonders einfach ausführbar und darüber hinaus lässt sich auf diese Art und Weise die Beleuchtung der Kontaktstiftanordnung 1 noch nachträglich eine bestehende Kontaktstiftanordnung hinzufügen. Anstelle der Schraubverbindung zwischen Anschlussstück 14 und Montagehülse 3 kann auch eine einfache Steckverbindung oder Bajonettverschluss-Verbindung vorgesehen sein. Die Steckverbindung bewirkt insbesondere eine Presspassung zwischen Anschlussstück 14 und Montagehülse 3, um ein sicheres Halten der Lichtquelle 15 an der Montagehülse 3 zu gewährleisten, insbesondere ohne dass hierfür eine bestehende Montagehülse 3 verändert werden müsste. Es muss lediglich der Außen- oder Innendurchmesser des Anschlussstücks 14 entsprechend gewählt werden, um die radiale Presspassung mit der Montagehülse zu realisierten.

Figur 16 zeigt ein sechzehntes Ausführungsbeispiel der Kontaktstiftanordnung 1, bei welcher der Kontaktstift 2 in die Montagehülse 3, wie sie im Ausführungsbeispiel der Figur 15 gezeigt ist, eingesetzt ist. Dazu ist der Kontaktstift 2 mit seinem der Montagehülse 3 zugewandten Ende in die Montagehülse 3 eingeschraubt. Gemäß dem vorliegenden Ausführungsbeispiel ist die Kontaktspitze 6 als Tellernadel mit einem ringförmigen Tellerkontakt 29 ausgebildet, der sich um den gesamten Umfang des Kontaktkolbens 5 beabstandet zu der Montagehülse 3 erstreckt. Die Lichtaustrittsöffnung 18 ist in diesem Fall an der axialen Stirnseite des Kontaktkolbens 5 ausgebildet und mündet in den axialen Lichtdurchgangskanal 19, der von einer Bohrung im Kontaktkolben 5 beziehungsweise durch die hohlzylinderförmige Ausbildung des Kontaktkolbens 5 sowie die Montagehülse 3 und die Mantelhülse 4 des Kontaktstifts 2 gebildet wird, sodass das von dem Leuchtmittel 16 erzeugte Licht durch den gesamten Kontaktstift 2 bis zur Lichtaustrittsöffnung 18 im Wesentlichen barrierefrei gelangt.

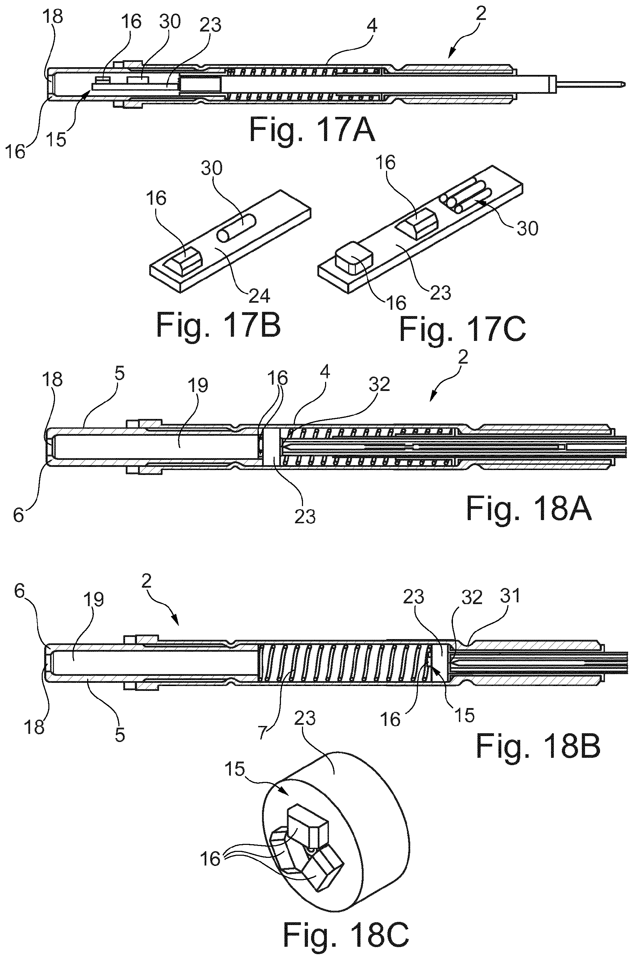

Figuren 17A bis C zeigen ein weiteres Ausführungsbeispiel der Kontaktstiftanordnung 1. Wie im Ausführungsbeispiel von Figur 3 ist dabei vorgesehen, dass das Leuchtmittel 16 auf der Leiterplatte 23 angeordnet ist, die axial in den Kontaktkolben 5 eingebaut ist. In dem Leuchtmittel 16 ist auch die Elektronik 30 auf der Leiterplatte 23 innerhalb des Kontaktkolbens 15 angeordnet.

Figur 17B zeigt dabei eine perspektivische Detailansicht der Leiterplatte 23 mit der Elektronik 30 und dem Leuchtelement 16. In diesem Ausführungsbeispiel ist das Leuchtelement 16 dazu ausgebildet, Licht axial in Richtung der axial ausgebildeten Lichtaustrittsöffnung 18 an der Kolbenspitze 16 abzustrahlen.

Figur 17C zeigt ein weiteres Ausführungsbeispiel, bei welchem auf der Leiterplatte zusätzlich zu dem Leuchtmittel 16, das axial abstrahlt, ein weiteres Leuchtmittel 16 vorgesehen ist, dass lateral beziehungsweise seitlich/radial abstrahlt und beispielsweise einer lateralen Lichtaustrittsöffnung 18 in der Mantelwand des Kontaktkolbens 5 (in Figur 17A nicht gezeigt) zugeordnet ist.

Figur 18 zeigt ein weiteres Ausführungsbeispiel, das sich von dem vorhergehenden Ausführungsbeispiel dadurch unterscheidet, dass die Leiterplatte 23 nicht plattenförmig ausgebildet und axial beziehungsweise längs, sondern scheibenförmig ausgebildet und radial beziehungsweise quer eingebaut ist. Dazu weist die Leiterplatte 23 eine kreisförmige Kontur auf, deren Außendurchmesser einem Innendurchmesser der Mantelhülse 4 des Kontaktstifts 2 entspricht, wie beispielhaft in Figur 18C gezeigt, die die Lichtquelle 15 mit einer scheibenförmigen Leiterplatte 23 in einer perspektivischen Darstellung zeigt. Die Leiterplatte 23 liegt somit quer in der Mantelhülse 4 beziehungsweise koaxial zu der Mantelhülse 4 ein. Gemäß dem Ausführungsbeispiel in Figur 18A ist vorgesehen, dass die Leiterplatte 23 an dem der Mantelhülse 4 zugewandten Ende des Kontaktkolbens 5 fest angeordnet ist und dadurch mit dem Kontaktkolben 5 mitbewegbar ist. An ihrer dem Kontaktkolben 5 zugewandten Stirnseite weist die Leitplatte 23 mehrere vorliegend drei, Leuchtmittel 16 auf, die insbesondere axial abstrahlend ausgebildet sind, um das Licht durch den Kontaktkolben 5 zu der axialen Lichtaustrittsöffnung 18 an der Kolbenspitze 6 zu senden. Die Leuchtmittel 16 sind dabei innerhalb des Kolbens 5 angeordnet, sodass sie alle im Lichtdurchgangskanal 19, den im Kontaktkolben 5 ausgebildet ist, liegen. In dem Ausführungsbeispiel ist der Kontaktstift 2 als Koaxialkontaktstift ausgebildet, der also mehrere parallel, nämlich koaxial zueinander verlaufende elektrische Strompfade aufweist, um einerseits die Leuchtmittel 16 beziehungsweise die Leiterplatte 19 und andererseits den Kontaktkolben 5 selbst elektrisch mit einer externen Einrichtung zu verbinden.

In dem Ausführungsbeispiel von Figur 18B ist im Unterschied zu dem Ausführungsbeispiel von Figur 18A vorgesehen, dass die Leiterplatte 23 fest in der Mantelhülse 4 angeordnet ist. Insbesondere ist die Leiterplatte 23 dabei derart angeordnet, dass das Federelement 7, das auch hier als Schraubenfeder ausgebildet ist, zwischen der Leiterplatte 23 und dem Kontaktkolben 5 verspannt ist. Hierdurch wird die Leiterplatte 23 durch die Federspannung des Federelements 7 gegen ein Axialanschlag der Mantelhülse 4, der durch eine weitere Verjüngung 31 der Mantelhülse 4 gebildet wird, gedrängt, und dadurch fest in der Mantelhülse 4 arretiert.

Die Leiterplatte 23 weist sowohl im Ausführungsbeispiel von Figur 18A als auch im Ausführungsbeispiel von Figur 18B an ihrer vom Kontaktkolben 5 abgewandten Rückseite ein oder mehrere Kontaktpads 32 auf, durch welche eine elektrische Berührungskontaktierung der Leiterplatte 23 mit den Strompfaden des Kontaktstifts 2 und gegebenenfalls der Montagehülse 3 ermöglicht ist.

Wie eingangs bereits erwähnt wird es durch die unterschiedlichen beispielhaft dargestellten Ausgestaltungen der Kontaktstiftanordnung 1 ermöglicht, dass eine Beleuchtung des jeweiligen Kontaktstifts 2 in die Kontaktstiftanordnung 1 integriert ist. Der Kontaktkolben 5 kann dabei, muss jedoch nicht, durch eine Feder 7 kraftbeaufschlagt sein. Es ist auch denkbar, den Kontaktkolben beispielsweise pneumatisch durch ein Betätigen des Mechanismus zu verlagern.

Die Beleuchtung des Kontaktstifts 2 bei den oben beschriebenen Ausführungsbeispielen kann dabei unterschiedliche Funktionen erfüllen. Zum einen dient das mindestens eine Leuchtmittel 16 dazu, an dem Testobjekt zugewandten Ende des Kontaktstifts 2 in visuelles Signal auszustrahlen. Die Hauptfunktion liegt dabei darin, für den Operator eine visuell warnende Signalgebung zu erzeugen, die insbesondere als Anweisung zur Durchführung eine den Beleuchtungszustand entsprechenden Tätigkeit gilt. Die elektrische Energie für die Beleuchtung wird extern dem Kontaktstift 2 bereitgestellt und über geeignete Verkabelung und Schnittstellen, wie obenstehend beschrieben, zugeführt. Die Beleuchtung kann dabei durch externe oder interne Verschaltungen/Befehle in verschiedene Zustände gebracht werden. Es ist beispielsweise auch möglich, das jeweilige Leuchtmittel 16 einzuschalten, sodass es kontinuierlich oder blinkend Licht erzeugt, und/oder mit einer bestimmten Farbe leuchtet oder eine Farbe wechselt. Weiterhin kann die Beleuchtung ausgeschaltet werden. Auch können mehrere Lichtquellen 15 unterschiedlich in einer Kombination der oben genannten Möglichkeiten betrieben werden. Die Zustände der Beleuchtung werden zweckmäßigerweise vom Operator in der Prüfroutine festgelegt oder können einem starren Ablauf folgen, um beispielsweise eine Montageanweisung zu realisieren, und/oder durch Ereignisse im Prüfablauf bedingt sein, also in Abhängigkeit von aktuellen Testergebnissen vorgegeben werden.

Während in den beschriebenen Ausführungsbeispielen die Leuchtmittel 16 stets als Leuchtdioden ausgebildet sind, ist es alternativ auch möglich, Laserdioden als Leuchtmittel vorzusehen. Das oder die Leuchtelemente 16 sind in den meisten Fällen dem Testobjekt und dem Operator zugewandt. Der Lichtaustritt befindet sich somit idealerweise an dem Kontaktkopf 5, wie in vielen der beschriebenen Ausführungsbeispiele gezeigt. Dabei ist die Lichtquelle 15 entweder unmittelbar am Lichtaustrittsort platziert oder durch eine geeignete Strahlenführung (Lichtdurchlasskanal 19) vorgesehen. Das jeweilige Leuchtmittel 16 kann dabei nah am Testobjekt beziehungsweise an der Kontaktspitze 16 angeordnet werden, um ein einfache Strahlenführung zu gewährleisten. Dies bedeutet jedoch eine etwas komplizierte elektrische Anbindung. Oder das Leuchtmittel 16 wird nah an der Anschlussseite des Kontaktstifts 2 angeordnet, was die elektrische Anbindung vereinfacht, die Strahlenführung jedoch etwas erschwert. Grundsätzlich kann die Lichtquelle 15 in dem Kontaktstift 2, insbesondere im Kolben mitbewegt oder mantelfest oder in der Mantelhülse 4 des Kontaktstifts 2 gehäusefest angeordnet werden. Alternativ wird die Lichtquelle 15 in der Montagehülse 3 in dem Kontaktstift 2 angeordnet. Besonders bevorzugt wird die Lichtquelle 15 in dem Anschlussstück 14 der Montagehülse 3 angeordnet, dass durch eine Steckverbindung, Schraubverbindung oder dergleichen an der Montagehülse 3 befestigbar/befestigt ist.

Als Träger für die Lichtquelle 15 liegen insbesondere die beschriebene Leiterplatte 23, die entweder plattenförmig ausgebildet und axial gelagert ist, wie in den Ausführungsbeispiel von Figuren 3 und 17 gezeigt, oder scheibenförmig und radial gelagert, wie in Ausführungsbeispiel von Figur 18 gezeigt. Die Leiterplatte 23 ist dabei ebenfalls axial beweglich oder ortsfest in der Kontaktstiftanordnung 1 angeordnet. Auf der Leiterplatte 23 sind neben den Leuchtmitteln 16 optional auch noch weitere elektronische Bauelemente zur Ansteuerung oder Erweiterung der Funktionalität der Lichtquelle 15 angeordnet. Alternativ sind speziell konzipierte Halterungen 20, die das jeweilige Leuchtmittel 16 aufnehmen, tragen und elektrisch an die Peripherie anwenden, vorhanden, wie beispielsweise in Figuren 2 und 10 bis 12 gezeigt. Die Halterung 20 kann dabei ebenfalls axial mit dem Kolben 5 mitbeweglich oder ortsfest in der Mantelhülse 4 der Kontaktstiftanordnung oder der Montagehülse 3 angeordnet sein.

Damit das von dem jeweiligen Leuchtmittel 16 erzeugte Licht für den Operator gut erkennbar ist, ist eine vorteilhafte Strahlenführung in die Lichtquelle 15 integriert oder vom Ort der Lichterzeugung abgekoppelt. Je nach Anordnung des Leuchtmittels 16 muss eine Lichtführung, gegebenenfalls durch mehrere Bauteile der Kontaktstiftanordnung 1 in einem durchgängigen Lichtdurchgangskanal 19 von dem Leuchtmittel bis zur Lichtaustrittsöffnung 18 erfolgen.

Dies kann beispielsweise durch eine gezielte Beeinflussung der Oberfläche des Lichtdurchgangskanals 19 und/oder der Lichtaustrittsöffnung 18 erreicht werden, wobei beispielsweise eine Totalreflektion mittels einer spiegelnder Oberfläche, beispielsweise durch den Reflektierungsring 25, definierter Streueffekte durch Rauigkeiten der Oberfläche, oder durch eine optische Streuung (Streuring 26') oder Einfärbung der Oberfläche erreicht werden. Auch sind die geometrische Beeinflussung des Lichtstrahls im Lichtdurchgangskanal 19 und/oder an der jeweiligen Lichtaustrittsöffnung 18 möglich, beispielsweise durch nicht axiale Anordnung oder Versatz von Bohrungen, definierte Durchmesseränderungen im oder über die Länge des Lichtdurchgangskanals 19, sowie durch Richtungsänderungen mittels Reflektion. Eine optische Beeinflussung des Lichtstrahls kann außerdem durch bestimmte Material- oder Struktureigenschaften sowie durch zusätzliche optische Bauelemente, wie beispielsweise eine Linse, Laser, Filter oder dergleichen erreicht werden.

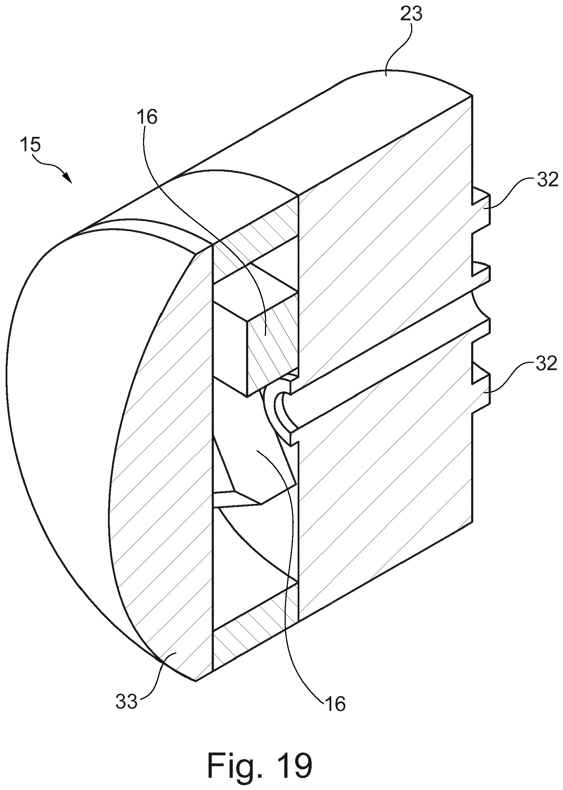

Figur 19 zeigt in einer perspektivischen Schnittdarstellung eine vorteilhafte Ausbildung der Lichtquelle 15 mit der scheibenförmigen Leiterplatte 23. Dabei unterscheidet sich die Lichtquelle 15 von dem Ausführungsbeispiel aus Figur 18C dadurch, dass den Leuchtmitteln 16 eine Sammellinse beziehungsweise ein Kollimator 33 nachgeschaltet ist, der das von den Leuchtmitteln 16 ausgestrahlte Licht bündelt und zu einem Strahlenbündel von parallel zueinander verlaufenden Lichtstrahlen überführt, die gezielt in den Lichtdurchgangskanal 19 und/oder zu der insbesondere axialen Lichtaustrittsöffnung 18 geführt werden. Durch die gebündelte Strahlenführung des Lichts werden Reflektionen und Absorptionen im Inneren des Kontaktstifts vermieden und eine hohe Lichtintensitäten an der jeweiligen Lichtaustrittsöffnung 18 gewährleistet. Insbesondere ist der Kollimator 33 auch bei den zuvor erläuterten Ausführungsbeispielen vorgesehen, insbesondere dann, wenn das von der Lichtquelle 15 erzeugte Licht durch einen Lichtkanal 19 oder durch eine axiale Lichtaustrittsöffnung 18 geführt wird.

Grundsätzlich können jeder Lichtquelle 15 ein oder mehrerer Lichtaustrittsöffnungen 18 zugeordnet sein, die axial und/oder radial zu der Lichtquelle angeordnet sind. Auch können die Lichtaustrittsöffnungen 18 axial relativ zu der Lichtquelle 15 bewegt werden, wenn sie beispielsweise im Kontaktkolben 5 ausgebildet sind. Dabei kann die jeweilige Austrittsöffnung zentrisch (beispielsweise Figur 3) oder exzentrisch (beispielsweise Figur 4 oder 9) an den jeweiligen Kontaktkolben 5 oder der Mantelhülse 4 ausgebildet sein. Auch kann die jeweilige Lichtaustrittsöffnung 18 am Umfang beziehungsweise Mantel des Kontaktkolbens 5, insbesondere der Kontaktspitze 6, für einen lateralen Austritt, gegebenenfalls mit axialer Strahlenumlenkung, vorgesehen sein. Durch mindestens eine Querbohrung oder Schlitz, der den Lichtdurchgangskanal 19 nach außen öffnet, ist eine derartige Strahlenumlenkung möglich. Dabei kann diese mitbewegt oder fest an der Mantelhülse 4 ausgebildet sein. Auch ist eine Strahlenumlenkung durch ein separates Bauteil, wie beispielsweise den Reflektionsring 25 möglich, der entweder mit dem Kontaktkolben 5 mitbewegt oder fest an der Mantelhülse 4 angeordnet ist.

Ist der Kontaktstift zur Berührungskontaktierung des Testobjekts ausgebildet, so ist zweckmäßigerweise eine galvanische Trennung zwischen der für die Lichtquelle 15 notwendigen elektrischen Leitung (Licht-Strompfad) und dem Test-Strompfad vorhanden. Grundsätzlich kann der Kontaktstift 2 als jegliche Art von Kontaktstift, wie beispielsweise als starrer Kontaktstift, als Schaltkontaktstift, Verrastkontaktstift, Tellernadelstift, Kelvinstift oder Hochschraubstift oder dergleichen ausgebildet sein. Die Kontaktspitze 6 kann ebenfalls unterschiedliche Formen aufweisen.

Bei der Integration der Beleuchtung in einen Schaltkontaktstift 2, wie beispielsweise in Figur 1 gezeigt, kann der Strompfad der Beleuchtung von einem elektrischen Teststrompfad des Kontaktstifts getrennt sein. Alternativ kann jedoch auch der Licht-Strompfad der Beleuchtung in den Schaltstrompfad integriert sein, sodass eine vom Kolbenhub abhängige Aktivierung der Leuchtmittel 16 ohne Umweg über eine periphere Prüftechnik erfolgt. Der Schaltzustand des Leuchtmittels 16 kann dabei direkt oder invers mit dem Zustand des (Schalt-) Kontaktstifts gekoppelt sein. Der Farbzustand der Lichtquelle kann beispielsweise ebenfalls mit dem Zustand des (Schalt-) Kontaktstifts gekoppelt sein, sodass beispielsweise bei einem Schalthub die Beleuchtung von Rot auf Grün wechselt. Zur elektrischen Kontaktierung der Beleuchtung insbesondere ein zweipolige Schnittstelle von externer Verkabelung vorgesehen und intern koaxial ausgeführt.

Um eine galvanische Trennung zu realisieren, ist insbesondere der Mantel beziehungsweise die Mantelhülse 4 des Kontaktstifts 2 aus einem elektrisch isolierenden Material, beispielsweise Kunststoff hergestellt. Dadurch wird eine notwendige separate Isolationsebenen eingespart. Der Testpunktstromkreis (Test-Strompfad beziehungsweise -strompfad) wird direkt vom Kontaktkolben zur 5 Montagehülse 3 geleitet. Die koaxial aneinanderliegenden Metallrohre der Kontaktstiftanordnung 1 werden mit einer dünnen isolierenden Beschichtung versehen, sodass auf übliche Isolations-Zwischenrohre oder breite Luftspalte verzichtet werden kann. Die elektrisch isolierende beziehungsweise hochohmige Beschichtung kann beispielsweise hergestellt werden durch eine verschleißarme Kunststoffbeschichtung, durch Aufbringen einer verschleißfesten Schicht mittels physikalischer oder chemischer Abscheidungstechnik, oder durch Erzeugung einer Metalloxidschicht, insbesondere Eloxar, was jedoch die Herstellung der Koaxialleiter aus Aluminium voraussetzt. Insbesondere weist der Kontaktstift 2 somit wenigstens eine aus Aluminium gefertigte Montagehülse auf, die mit einer Metalloxidschicht versehen ist. Insgesamt ist grundsätzlich vorgesehen, dass die Strompfade beziehungsweise metallische Leiter von Strompfaden der Kontaktstiftanordnung mit einer isolierenden "Haut" oder Schicht versehen sind, welche die galvanische Trennung zu benachbarten Strompfaden oder elektrisch leitfähigen Elementen gewährleistet. Gleichzeitig ist diese Schicht bevorzugt als mechanische Schnittstelle beweglicher Bauteile ausgebildet, beispielsweise zur Gleitführung von Kontaktkolben 5 und Mantelhülse 4. Dadurch können Leiter beziehungsweise Strompfade berühren, platzsparend, vorzugsweise koaxial, und längsverschiebbar zueinander angeordnet werden. Als elektrische Leiter können dabei stabförmige Bauteile, aber auch rohrförmige beziehungsweise hülsenförmige Bauteile oder Federelemente, insbesondere Schraubenfedern der Kontaktstiftanordnung 1 dienen.

Weiterhin ist die elektrische Kontaktierung der Leuchtmittel 16 mittels der Leiterplatte 23 optional durch das Federelement 7 realisiert, das dann selbst als elektrisch leitfähiges Kontaktelement ausgebildet ist und einen Abschnitt eines Strompfads durch den Kontaktstift bildet. Dadurch erfolgt eine Funktionsintegration in das Federelement 7, das dann einerseits die Federkraft und andererseits die elektrische Kontaktierung zur Verfügung stellt. Insbesondere ist vorgesehen, dass zwei Federn, insbesondere Schraubenfedern, anstellen des einen Federelements 7 koaxial ineinanderlaufend angeordnet sind, um unterschiedliche elektrische Potentiale für die elektrische Kontaktierung zur Verfügung zu stellen, wobei die Potentialtrennung zwischen den einzelnen Federelementen dann durch insbesondere ein zusätzliches Kunststoffrohr oder eine insbesondere dünne isolierende Beschichtung auf zumindest einem der Federelemente erfolgt.

Während einige der erläuterten Ausführungsbeispiele mit einer zusätzlichen Reflektionsfläche arbeiten, um eine vorteilhafte Lichtabstrahlung zu erreichen, ist es gemäß einem weiteren Ausführungsbeispiel auch möglich, wie beispielsweise im Ausführungsbeispiel von Figur 1 oder 2 gezeigt, ohne eine zusätzliche Reflektionsfläche am Lichtaustritt, also ohne zusätzliche Lichtführungsstrukturen am Lichtaustritt zu arbeiten. Vielmehr kann das Testobjekt beziehungsweise der Prüfling selbst als Reflektionsfläche/Reflektionsobjekt genutzt werden. Dies funktioniert beispielsweise dann, wenn der Kontaktkolben mit seinem Lichtaustritt in ein metallisch glänzendes Kontaktelement des Steckverbinders (Testobjekt) und/oder in dessen Kunststoffkavität mit glatter Oberfläche hineinragt oder nahe daran liegt. Schräg von unten in die Kavität einstrahlendes Licht wird dann vom Operator/Bediener von oben sichtbar, weil die Wände der Kavität angestrahlt werden und selbst leuchtend erscheinen. Selbstverständlich kann dies auch angewendet werden, wenn die Lichtquelle 15 dazu ausgebildet ist, Licht im nicht-sichtbaren Bereich auszusenden. Darüber hinaus kann anhand der Reflektion am Testobjekt außerdem eine weitere Information, beispielsweise über die korrekte Anordnung und/oder Sitz des Kontaktkolbens beziehungsweise der Kontaktspitze innerhalb der Kavität des Prüflings/Testobjekts, erhalten werden, indem beispielsweise die Reflektionsrichtung und/oder Intensität geprüft und ausgewertet wird.

Wie bereits erwähnt, kann die Lichtquelle 15 durch externe Technik gesteuert werden, beispielsweise in Abhängigkeit von der Berührung der Kontaktfläche eines Testobjekts, abhängig vom Kolbenhub des Kontaktkolbens 5 oder unabhängig von Berührung und/oder Kolbenhub. Auch ist eine interne Steuerung der Beleuchtung möglich, wie bereits erwähnt, durch Berühren der Kontaktfläche des Testobjekts, dem Schaltzustand des Schaltkontaktstifts oder unabhängig vom Schaltzustand und nicht elektrisch über eine optische Beeinflussung der Strahlenführung und/oder des Lichtaustritts, durch entsprechende Anordnung einer oder mehrerer Lichtaustrittsöffnungen, die bei der Bewegung des Kontaktkolbcns beispielsweise von der Mantelhülse 4 verdeckt oder freigegeben werden.

Um die Lichtquelle 15 vor einer Verschmutzung zu schützen, die beispielsweise durch den mechanischen Verschleiß des Kontaktstifts 2 entsteht, sind Lichtquelle, Lichtaustrittsöffnung(en) 18 und/oder Lichtdurchführungskanal 19 insbesondere verkapselt, beispielsweise durch einen transparenten Verguss oder ein transparentes Element, wie beispielsweise den transparenten Streuring 26' aus Figur 5E. Die Lichtaustrittsöffnung 18 ist bevorzugt räumlich von der Kontaktstelle getrennt, insbesondere hinter der Kontaktstelle axial zurückversetzt, axial und lateral zur Lichtquelle versetzt oder durch einen lateralen Lichtaustritt am Kontaktkolben an der Kontaktspitze 6 mit oder ohne Strahlenumlenkung.

Intensität und Kontrast der Lichtquelle 15 sind insbesondere von den Umgebungsbedingungen abhängig. Einen Mehrwert ergibt sich dann, wenn diese Parameter vom Operator oder automatisiert eingestellt werden. Dazu kann die integrierte Elektronik 30 auf der Leiterplatte 23 oder die externe Einrichtung genutzt werden.

Vorzugsweise werden die jeweiligen Leuchtmittel 16 durch eine Farbcodierung in Abhängigkeit unterschiedlicher Zustände oder zur Montageanleitung angesteuert/aktiviert. Auch die Farbcodierung wird entweder intern, durch die Elektronik 30 selbst, oder durch die externe Einrichtung vorgegeben.

In den vorliegenden Ausführungsbeispielen ist die Lichtquelle 15 zur Erzeugung von vom menschlichen Auge wahrnehmbare Licht ausgebildet. Unter Hinzunahme eines optischen Empfängers kann jedoch auch die Erkennung von Lichtsignalen automatisiert werden, wobei dann auch Lichtquellen 15 verwendet werden können, deren Leuchtmittel Licht im für das menschliche Auge nicht mehr wahrnehmbaren Bereich, insbesondere im Infrarot oder Ultraviolett-Spektrum, erzeugen. Die optischen Merkmalsdetektion erfolgt dann insbesondere über die vom Testobjekt reflektierte Intensität oder bestimmter Wellenlängenverschiebungen zur Farberkennung. Der Empfänger ist dann bevorzugt in demselben Kontaktstift 2 wie die Lichtquelle 15 angeordnet. Die dann erzeugbare Signalgebung erlaubt dabei beispielsweise das einfache automatisierte Feststellen der Anwesenheit des Kontaktelements in der richtigen Kavität eines zu prüfenden Steckverbinders, die Anwesenheit des richtigen Kontaktelements beziehungsweise Testobjekts, die mechanisch korrekte Anordnung in axialer oder lateraler Lage des Testobjekts oder eines Kontaktelements des Testobjekts, eine Deformation des Kontaktelements und oder die Anwesenheit in korrekter Lage eines Steckergehäuses in der Prüfvorrichtung.

## Patentansprüche

1. Kontaktstiftanordnung (1) mit einem Kontaktstift (2) und mit einer den Kontaktstift (2) zumindest teilweise aufnehmenden Montagehülse (3), wobei der Kontaktstift (2) einen in einer Mantelhülse (4) verschieblich geführten Kontaktkolben (5) aufweist, **gekennzeichnet durch** mindestens eine der Montagehülse (3) zugeordnete Lichtquelle (15), die zumindest ein elektrisch aktivierbares Leuchtmittel (16) aufweist, wobei der Kontaktstift (2) mindestens einen mit zumindest einer Lichteintritts- und zumindest einer Lichtaustrittsöffnung (18) versehenen Lichtdurchgangskanal (19) für von der Lichtquelle (15) ausgesandtes Licht besitzt, und wobei die Lichtquelle in oder an der Montagehülse (3) angeordnet ist.

2. Kontaktstiftanordnung nach Anspruch 1, **dadurch gekennzeichnet, dass** die Lichtquelle (15) in oder an der Montagehülse (3) auswechselbar angeordnet ist.

3. Kontaktstiftanordnung nach Anspruch 2, **dadurch gekennzeichnet, dass** die Lichtquelle (15) in einem Anschlussstück (14) angeordnet ist, das durch eine Steckverbindung, die insbesondere eine Presspassung zwischen Anschlussstück (14) und Montagehülse (3) bewirkt, oder durch eine Bajonettverschluss-Verbindung an der Montagehülse (3) befestigt ist.

4. Kontaktstiftanordnung nach einem der vorhergehenden Ansprüche, **dadurch gekennzeichnet, dass** die Lichtaustrittsöffnung (18) an oder im Bereich einer Kontaktierungsfläche (22) und/oder zur Kontaktierungsfläche (22) benachbarter Fläche/Flächen des Kontaktkolbens (5) und/oder an oder im Bereich eines dem Kontaktkolben (5) benachbart liegenden Endes der Mantelhülse (4) liegt.

5. Kontaktstiftanordnung nach einem der vorhergehenden Ansprüche, **dadurch gekennzeichnet, dass** die Lichtquelle (15) dazu ausgebildet ist, Licht im für das menschliche Auge sichtbaren Spektrum oder im nicht-sichtbaren Spektrum, insbesondere im IR-Spektrum oder im UV-Spektrum auszuenden.

6. Kontaktstiftanordnung nach einem der vorhergehenden Ansprüche, **dadurch gekennzeichnet, dass** die Lichtquelle (15) dazu ausgebildet ist, betriebszustandsabhängig Licht in unterschiedlichen Farben aus zu senden.

7. Kontaktstiftanordnung nach einem der vorhergehenden Ansprüche, **dadurch gekennzeichnet, dass** die Lichtquelle (15) im die Kontaktierungsfläche (22) aufweisenden Endbereich des Kontaktkolbens (5), angrenzend an die Lichtaustrittsöffnung (18) angeordnet ist, oder dass die Lichtquelle (15) Licht in einen Lichtdurchgangskanal (19) einstrahlt, der die Lichtaustrittsöffnung (18) aufweist.

8. Kontaktstiftanordnung nach einem der vorhergehenden Ansprüche, **dadurch gekennzeichnet, dass** der Lichtquelle (15) ein Kollimator (33) zugeordnet ist.

9. Kontaktstiftanordnung nach einem der vorhergehenden Ansprüche, **dadurch gekennzeichnet, dass** der Lichtdurchgangskanal (19) den Kontaktkolben (5), ein dem Kontaktkolben zugeordnetes Federelement (7), die Mantelhülse (4), einen in der Mantelhülse (4) liegenden Innenaufbau des Kontaktstifts (2) und/oder den gesamten Kontaktstift (2) zumindest bereichsweise durchsetzt.

10. Kontaktstiftanordnung nach einem der vorhergehenden Ansprüche, **dadurch gekennzeichnet, dass** die Lichtquelle (15) an einen elektrischen Strompfad angeschlossen ist, der zu einer von außen zugänglichen elektrischen Schnittstelle (12) des Kontaktstifts (2) oder der Montagehülse (3) für den Kontaktstift (2) führt.

11. Kontaktstiftanordnung nach Anspruch 10, **dadurch gekennzeichnet, dass** der Strompfad zumindest abschnittsweise von einem den Kontaktkolben (5) mit einer Federkraft beaufschlagendes Federelement (7) gebildet wird, das elektrisch leitfähig ausgebildet ist.

12. Kontaktstiftanordnung nach einem der vorhergehenden Ansprüche, **dadurch gekennzeichnet, dass** der Lichtdurchgangskanal (19) mindestens ein Lichtbeeinflussungsmittel aufweist, das insbesondere als ein Lichtreflektionsmittel (23), ein Lichtstreumittel (26'), ein Lichteinfärbungsmittel, mindestens eine optische Linse, insbesondere Kollimator, mindestens ein Lichtfilter und/oder mindestens eine Lichtblende ist.

13. Kontaktstiftanordnung nach einem der vorhergehenden Ansprüche, **dadurch gekennzeichnet, dass** die Lichtquelle (15), insbesondere ein Licht-Strompfad, elektrisch galvanisch getrennt ist von mindestens einem elektrischen Test-Strompfad des Kontaktstifts (2) und/oder der Montagehülse (3).

14. Kontaktstiftanordnung nach einem der vorhergehenden Ansprüche, **dadurch gekennzeichnet, dass** der Lichtdurchgangskanal (19) zumindest abschnittsweise entlang, parallel und/oder schrägwinklig zu einer Mittellängsachse des Kontaktstifts (2) oder der Montagehülse (3) verläuft.

15. Kontaktstiftanordnung nach einem der vorhergehenden Ansprüche, **dadurch gekennzeichnet, dass** die Lichtquelle (15) in Abhängigkeit der Stellung des längsverschieblich geführten Kontaktkolbens (5) angesteuert wird.

## Claims

1. Contact pin arrangement (1) with a contact pin (2) and with a mounting sheath (3) at least partially accommodating the contact pin (2), wherein the contact pin (2) has a contact plunger (5) guided displaceably in a casing sheath (4), **characterised by** at least one light source (15) assigned to the mounting sheath (3) and having at least one electrically operable lamp (16), wherein the contact pin (2) has at least one light transmission channel (19) with at least one light entry opening and at least one light exit opening (18) for light emitted from the light source (15), said light source being arranged in or on the mounting sheath (3).

2. Contact pin arrangement according to claim 1, **characterised in that** the light source (15) is arranged replaceably in or on the mounting sheath (3).

3. Contact pin arrangement according to claim 2, **characterised in that** the light source (15) is arranged in a connecting piece (14) which is fastened to the mounting sheath (3) by means of a plug-in connection which effects in particular an interference fit between the connecting piece (14) and the mounting sheath (3), or by means of a bayonet catch connection.

4. Contact pin arrangement according to any one of the preceding claims, **characterised in that** the light exit opening (18) lies at or in the region of a contact surface (22) and/or of a surface or surfaces of the contact plunger (5) adjacent to the contact surface (22) and/or at or in the region of an end of the casing sheath (4) adjacent to the contact plunger (5).

5. Contact pin arrangement according to any one of the preceding claims, **characterised in that** the light source (15) is configured to emit light in the spectrum visible to the human eye or in the non-visible spectrum, particularly in the IR spectrum or UV spectrum.

6. Contact pin arrangement according to any one of the preceding claims, **characterised in that** the light source (15) is configured to emit light of different colours dependent on the operating state.

7. Contact pin arrangement according to any one of the preceding claims, **characterised in that** the light source (15) is arranged in the end region of the contact plunger (5) having the contact surface (22), adjacent to the light exit opening (18), or **in that** the light source (15) beams light into a light transmission channel (19) which has the light exit opening (18).

8. Contact pin arrangement according to any one of the preceding claims, **characterised in that** the light source (15) is assigned a collimator (33).

9. Contact pin arrangement according to any one of the preceding claims, **characterised in that** the light transmission channel (19) penetrates at least regionally the contact plunger (5), a spring element (7) assigned to the contact plunger, the casing sheath (4), an internal structure of the contact pin (2) residing in the casing sheath (4) and/or the entire contact pin (2).

10. Contact pin arrangement according to any one of the preceding claims, **characterised in that** the light source (15) is connected to an electric current path which leads to an externally accessible electric interface (12) of the contact pin (2) or of the mounting sheath (3) for the contact pin (2).

11. Contact pin arrangement according to claim 10, **characterised in that** the current path is provided at least in sections by a spring element (7) which is electrically conductive and applies a spring force to the contact plunger (5).

12. Contact pin arrangement according to any one of the preceding claims, **characterised in that** the light transmission channel (19) has at least one light influencing means, which in particular is provided as a light reflection means (23), a light diffusion means (26'), a light colouring means, at least one optical lens, in particular a collimator, at least one light filter and/or at least one light screen.

13. Contact pin arrangement according to any one of the preceding claims, **characterised in that** the light source (15), in particular a light current path, is electrically galvanically separated from at least one electric test current path of the contact pin (2) and/or mounting sheath (3).

14. Contact pin arrangement according to any one of the preceding claims, **characterised in that** the light transmission channel (19) extends at least in sections along, parallel to or at a skewed angle to a central longitudinal axis of the contact pin (2) or of the mounting sheath (3).

15. Contact pin arrangement according to any one of the preceding claims, **characterised in that** the light source (15) is triggered depending on the position of the longitudinally displaceably guided contact plunger (5).

## Revendications

1. Agencement de broche de contact (1) comportant une broche de contact (2) et comportant une douille de montage (3) logeant au moins partiellement la broche de contact (2), dans lequel la broche de contact (2) présente un piston de contact (5) guidé en coulissement dans une douille d'enveloppe (4), **caractérisé par** au moins une source de lumière (15) associée à la douille de montage (3), laquelle présente au moins une lampe (16) électriquement activable, dans lequel la broche de contact (2) possède au moins un canal de passage de la lumière (19), prévu avec au moins une ouverture d'entrée de la lumière et au moins une ouverture de sortie de la lumière (18), pour la lumière émise par la source lumineuse (15), et dans lequel la source lumineuse est disposée dans ou à la douille de montage (3).

2. Agencement de broche de contact selon la revendication 1, **caractérisé en ce que** la source lumineuse (15) est disposée dans ou à la douille de montage (3) de manière amovible.

3. Agencement de broche de contact selon la revendication 2, **caractérisé en ce que** la source lumineuse (15) est disposée dans une pièce de raccordement (14), laquelle est fixée sur la douille de montage (3) au moyen d'une connexion enfichable, laquelle provoque en particulier un ajustement serré entre la pièce de raccordement (14) et la douille de montage (3), ou au moyen d'une connexion baïonnette.

4. Agencement de broche de contact selon l'une des revendications précédentes, **caractérisé en ce que** l'ouverture de sortie de la lumière (18) se trouve sur ou au niveau d'une surface de contact (22) et/ou d'une ou plusieurs surface(s) du piston de contact (5) adjacente(s) à la surface de contact (22) et/ou sur ou au niveau d'une extrémité de la douille d'enveloppe (4) adjacente au piston de contact (5).

5. Agencement de broche de contact selon l'une des revendications précédentes, **caractérisé en ce que** la source lumineuse (15) est réalisée de façon à émettre de la lumière dans le spectre visible par l'oeil humain ou dans le spectre invisible, en particulier dans le spectre infrarouge ou dans le spectre ultraviolet.

6. Agencement de broche de contact selon l'une des revendications précédentes, **caractérisé en ce que** la source lumineuse (15) est réalisée de façon à émettre de la lumière de différentes couleurs en fonction de l'état de fonctionnement.

7. Agencement de broche de contact selon l'une des revendications précédentes, **caractérisé en ce que** la source lumineuse (15) est disposée dans la zone de l'extrémité du piston de contact (5) comprenant la surface de contact (22), adjacente à l'ouverture de sortie de la lumière (18), ou **en ce que** la source lumineuse (15) rayonne la lumière dans un canal de passage de la lumière (19), lequel présente l'ouverture de sortie de la lumière (18).

8. Agencement de broche de contact selon l'une des revendications précédentes, **caractérisé en ce que** la source lumineuse (15) est associée à un collimateur (33).

9. Agencement de broche de contact selon l'une des revendications précédentes, **caractérisé en ce que** le canal de passage de la lumière (19) traverse au moins par sections le piston de contact (5), un élément élastique (7) associé au piston de contact, la douille d'enveloppe (4), une structure interne, située dans la douille d'enveloppe (4), de la broche de contact (2) et/ou la totalité de la broche de contact (2).

10. Agencement de broche de contact selon l'une des revendications précédentes, **caractérisé en ce que** la source lumineuse (15) est raccordée à un trajet de courant électrique, lequel conduit à une interface électrique (12) de la broche de contact (2) ou de la douille de montage (3) pour la broche de contact (2), accessible de l'extérieur.

11. Agencement de broche de contact selon la revendication 10, **caractérisé en ce que** le trajet de courant est formé au moins en partie par un élément élastique (7), réalisé pour être électriquement conducteur, appliquant une force élastique au piston de contact (5).

12. Agencement de broche de contact selon l'une des revendications précédentes, **caractérisé en ce que** le canal de passage de la lumière (19) présente au moins un moyen d'influence de la lumière, lequel est en particulier un moyen de réflexion de la lumière (23), un moyen de diffusion de la lumière (26'), un moyen de coloration de la lumière, au moins une lentille optique, en particulier un collimateur, au moins un filtre de lumière et/ou au moins un cache-lumière.

13. Agencement de broche de contact selon l'une des revendications précédentes, **caractérisé en ce que** la source lumineuse (15), en particulier un trajet de courant lumière, est électriquement galvaniquement séparée d'au moins un trajet de courant électrique de test de la broche de contact (2) et/ou de la douille de montage (3).

14. Agencement de broche de contact selon l'une des revendications précédentes, **caractérisé en ce que** le canal de passage de la lumière (19) s'étend au moins partiellement le long d'un axe médian longitudinal de la broche de contact (2) ou de la douille de montage (3), en parallèle et/ou à angle oblique.

15. Agencement de broche de contact selon l'une des revendications précédentes, **caractérisé en ce que** la source lumineuse (15) est commandée en fonction de la position du piston de contact (5) guidé en coulissement dans la longueur.
